# EUROPEAN PATENT APPLICATION

(11) **EP 4 730 970 A1**
(43) Date of publication of application: **22.04.2026**
(21) Application number: 25205601.5
(22) Date of filing: 30.09.2025
(51) Int. Cl.: H10K 59/121, H10K 59/38

(54) **DISPLAY DEVICE AND ELECTRONIC DEVICE**

(30) Priority: 15.10.2024 KR 20240140088
(71) Applicant: Samsung Display Co., Ltd., Yongin-si, Gyeonggi-do 17113 (KR)
(72) Inventor: KIM, Min Seok, Yongin-si (KR); NAM, Dong Hun, Yongin-si (KR); SON, Dong Hyun, Yongin-si (KR); KIM, Eun Hye, Yongin-si (KR); LEE, So La, Yongin-si (KR); LEE, Seong Jun, Yongin-si (KR)
(74) Representative: Marks & Clerk LLP

(57) **Abstract**

A display device includes a display panel including a main region including a main pixel including first to third main emission areas emitting light of first to third colors, respectively, and a sub-region including a transmission area and a sub-pixel including first to third sub-emission areas emitting light of the first to third colors, respectively. The display panel includes: a light blocking layer on a display layer; a first color filter layer on the light blocking layer; a second color filter layer on the first color filter layer; and a third color filter layer on the second color filter layer. The first to third color filter layers include first to third main color portions in the main region and first to third sub-color portions in the sub-region. An area ratio between the first to third main color portions differs from an area ratio between the first to third sub-color portions.

## Description

### BACKGROUND

### 1. Field

One or more embodiments of the present disclosure relate to a display device and an electronic device including the same.

### 2. Description of the Related Art

With the advancement of the information-oriented society, there is an increasing demand for display devices capable of displaying images in versatile ways. Display devices are extensively employed in suitable electronic devices such as smartphones, digital cameras, laptop computers, navigation devices, and/or smart televisions.

As electronic devices employing display devices diversify and spread, there is a growing need or desire for display devices to be provided in various suitable designs. For instance, in the case of a smartphone, there is a requirement or desire for display devices that widen the display area by eliminating one or more holes on the front surface. In this regard, optical devices that would typically be arranged in a hole on the front surface of the display device may be arranged to overlap with the display pane of the display device.

### SUMMARY

One or more aspects of embodiments of the present disclosure are directed toward a display device with an improved reflection color and an electronic device including the display device.

However, aspects of the present disclosure are not restricted to those set forth herein. The above and other aspects of the present disclosure will become more apparent to one of ordinary skill in the art to which the present disclosure pertains by referencing the detailed description of the present disclosure provided herein or learning by practice of the presented embodiments of the disclosure.

According to one or more embodiments of the present disclosure, a display device includes a display panel including a main region including a main pixel, and a sub-region including a transmission area and a sub-pixel, wherein the main pixel includes first to third main emission areas configured to emit light of first to third colors, respectively, the sub-pixel includes first to third sub-emission areas configured to emit light of the first to third colors, respectively, and the display panel includes, a display layer, a light blocking layer on (e.g., arranged on) the display layer, a first color filter layer on (e.g., arranged on) the light blocking layer and transmitting light of the first color, a second color filter layer on (e.g., arranged on) the first color filter layer and transmitting light of the second color, and a third color filter layer on (e.g., arranged on) the second color filter layer and transmitting light of the third color, wherein the first to third color filter layers include first to third main color portions overlapping the first to third main emission areas, respectively, and first to third sub-color portions overlapping the first to third sub-emission areas, respectively, and an area ratio between the first to third main color portions is different from an area ratio between the first to third sub-color portions.

In one or more embodiments, a size or area of the second sub-color portion is smaller than a size or area of each of the first sub-color portion and the third sub-color portion.

In one or more embodiments, a second area obtained by excluding an area of the second sub-emission area from the area of the second sub-color portion is smaller than at least one of a first area obtained by excluding an area of the first sub-emission area from the area of the first sub-color portion or a third area obtained by excluding an area of the third sub-emission area from the area of the third sub-color portion.

In one or more embodiments, an area of the second sub-color portion covering a top surface of the light blocking layer is smaller than at least one of an area of the first sub-color portion covering a top surface of the light blocking layer or an area of the third sub-color portion covering a top surface of the light blocking layer.

In one or more embodiments, the transmission area is repeatedly arranged in a first direction and a second direction, on a plane viewed from a third direction, the sub-region includes a central area and a bridge area where at least a part of the sub-pixel is arranged, the central area is arranged between the transmission areas in the first direction and the second direction, on the plane viewed from the third direction, and the bridge area is arranged between the transmission areas in a fourth direction and a fifth direction different from the first direction and the second direction, on the plane viewed from the third direction.

In one or more embodiments, the first sub-emission area and the second sub-emission area are arranged alternately in the fourth direction, and the second sub-emission area and the third sub-emission area are arranged alternately in the fifth direction.

In one or more embodiments, a length of the first sub-color portion in the fourth direction is greater than a length thereof in the fifth direction, on the plane viewed from the third direction.

In one or more embodiments, in at least one of the fourth direction or the fifth direction, a length of the third sub-color portion is greater than that of the first sub-color portion, on the plane viewed from the third direction.

In one or more embodiments, a size or area of the second sub-color portion is smaller than a size or area of each of the first sub-color portion and the third sub-color portion.

In one or more embodiments, the sub-pixel further includes a fourth sub-emission area configured to emit light of the first color, a fifth sub-emission area configured to emit light of the second color, a sixth sub-emission area configured to emit light of the third color, and a seventh sub-emission area configured to emit light of the second color, the first to fourth sub-emission areas and the sixth sub-emission area are in (e.g., arranged in) the central area, and the fifth sub-emission area and the seventh sub-emission area are in (e.g., arranged in) the bridge area.

In one or more embodiments, the light blocking layer includes a transmission window opening in (e.g., arranged in) the transmission area.

In one or more embodiments, at least one of (e.g., at least one selected from among) the first to third sub-color portions is in (e.g., arranged in) the transmission area.

According to one or more embodiments of the present disclosure, a display device includes a display panel including a main region including a main pixel, and a sub-region including a transmission area and a sub-pixel, wherein the main pixel includes first to third main emission areas configured to emit light of first to third colors, respectively, the sub-pixel includes first to third sub-emission areas configured to emit light of the first to third colors, respectively, and the display panel includes, a display layer, a first color filter layer on (e.g., arranged on) the display layer and configured to transmit light of the first color, a second color filter layer on (e.g., arranged on) the first color filter layer and configured to transmit light of the second color, and a third color filter layer on (e.g., arranged on) the second color filter layer and configured to transmit light of the third color, wherein the first color filter layer includes a first sub-color opening overlapping the second sub-emission area and the third sub-emission area, and a first color transmission window opening in (e.g., arranged in) the transmission area, the second color filter layer includes a second sub-color opening overlapping the first sub-emission area and the third sub-emission area, and a second color transmission window opening in (e.g., arranged in) the transmission area, the third color filter layer includes a third sub-color opening overlapping the first sub-emission area and the second sub-emission area, and a third color transmission window opening in (e.g., arranged in) the transmission area, and the second sub-color opening has a size or area larger than that of at least one of the first sub-color opening or the third sub-color opening.

In one or more embodiments, the sub-region includes a black blocking area where all the first to third color filter layers overlap.

In one or more embodiments, the sub-region includes a color blocking area where the first color filter layer and the third color filter layer overlap and the second color filter layer is not arranged (e.g., does not overlap).

In one or more embodiments, a size or area of the second sub-color opening overlapping the first sub-emission area among the second sub-color openings is smaller than a size or area of the second sub-color opening overlapping the third sub-emission area among the second sub-color openings.

In one or more embodiments, the transmission area is repeatedly arranged in a first direction and a second direction, on a plane viewed from a third direction (in plan view), the sub-region includes a central area and a bridge area where at least a part of the sub-pixel is arranged, the central area is arranged between the transmission areas in the first direction and the second direction, on the plane viewed from the third direction, and the bridge area is arranged between the transmission areas in a fourth direction and a fifth direction different from the first direction and the second direction, on the plane viewed from the third direction (in plan view).

In one or more embodiments, the first sub-emission area and the second sub-emission area are arranged alternately in the fourth direction, and the second sub-emission area and the third sub-emission area are arranged alternately in the fifth direction.

In one or more embodiments, among the second sub-color openings, the second sub-color opening overlapping the first sub-emission area is arranged in the fourth direction, and among the second sub-color openings, the second sub-color opening overlapping the third sub-emission area is arranged in the fifth direction.

In one or more embodiments, at least one of (e.g., at least one selected from among) the first to third sub-color openings is not arranged in the transmission area.

At least some of the above and other features of the invention are set out in the claims.

In accordance with a display device according to one or more embodiments of the present disclosure, a reflection color may be improved. For example, this improvement in reflection color is achieved through the enhanced arrangement of color filter layers and emission areas, which ensures that light is transmitted and reflected in a manner that reduces color distortion and enhances color fidelity. By designing the overlap and arrangement of the color filter layers, the display device may maintain consistent and high-quality color representation even in varying lighting conditions. This results in more accurate and vibrant colors, enhancing the overall visual experience. Additionally, the improved reflection color contributes to better readability and visibility of the display, making it more suitable for use in a wide range of applications. The design also supports high-resolution displays with minimal or reduce bezels.

It should be noted that effects and aspects of the present disclosure are not limited to those described above, and other effects and aspects of the present disclosure will be apparent to those skilled in the art from the following descriptions.

### BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects and features of the present disclosure will become more apparent appreciated from the following descriptions of example embodiments thereof with reference to the accompanying drawings, in which:
FIG. 1 is a perspective view showing a display device according to one or more embodiments of the present disclosure;
FIG. 2 is a plan view illustrating a display device according to one or more embodiments of the present disclosure;
FIG. 3 is a cross-sectional view of the display device taken along the line X1-X1' of FIG. 2 according to one or more embodiments of the present disclosure;
FIG. 4 is an enlarged view of area A of FIG. 2 according to one or more embodiments of the present disclosure;
FIG. 5 is a plan view illustrating a sub-display area according to one or more embodiments of the present disclosure;
FIG. 6 is a layout diagram showing a light blocking layer, a first color filter layer, a second color filter layer, and a third color filter layer in a first main pixel according to one or more embodiments of the present disclosure;
FIG. 7 is a layout diagram showing a light blocking layer in a first main pixel according to one or more embodiments of the present disclosure;
FIG. 8 is a layout diagram showing a first color filter layer in a first main pixel according to one or more embodiments of the present disclosure;
FIG. 9 is a layout diagram showing a second color filter layer in a first main pixel according to one or more embodiments of the present disclosure;
FIG. 10 is a layout diagram showing a third color filter layer in a first main pixel according to one or more embodiments of the present disclosure;
FIG. 11 is a cross-sectional view taken along the line X2-X2' of FIG. 6 according to one or more embodiments of the present disclosure;
FIG. 12 is a layout diagram showing a light blocking layer, a first color filter layer, a second color filter layer, and a third color filter layer in area C of FIG. 4 according to one or more embodiments of the present disclosure;
FIG. 13 is a layout diagram showing a light blocking layer in area C of FIG. 4 according to one or more embodiments of the present disclosure;
FIG. 14 is a layout diagram showing a first color filter layer in area C of FIG. 4 according to one or more embodiments of the present disclosure;
FIG. 15 is a layout diagram showing a second color filter layer in area C of FIG. 4 according to one or more embodiments of the present disclosure;
FIG. 16 is a layout diagram showing a third color filter layer in area C of FIG. 4 according to one or more embodiments of the present disclosure;
FIG. 17 is a cross-sectional view taken along the line X3-X3' of FIG. 12 according to one or more embodiments of the present disclosure;
FIG. 18 is a cross-sectional view taken along the line X4-X4' of FIG. 12 according to one or more embodiments of the present disclosure;
FIG. 19 is a cross-sectional view taken along the line X5-X5' of FIG. 12 according to one or more embodiments of the present disclosure;
FIG. 20 is a graph showing a'-b' color difference plots of display devices according to a comparative example and one embodiment of the present disclosure, which were measured by a Specular Component Excluded (SCE) measurement method;
FIG. 21 is a layout diagram showing a first color filter layer, a second color filter layer, and a third color filter layer in a sub-display area according to one or more embodiments of the present disclosure;
FIG. 22 is a layout diagram showing the first color filter layer in the sub-display area according to one or more embodiments of the present disclosure;
FIG. 23 is a layout diagram showing the second color filter layer in the sub-display area according to one or more embodiments of the present disclosure;
FIG. 24 is a layout diagram showing the third color filter layer in the sub-display area according to one or more embodiments of the present disclosure;
FIG. 25 is a cross-sectional view taken along the line X6-X6' in FIG. 21 according to one or more embodiments of the present disclosure;
FIG. 26 is a cross-sectional view taken along the line X7-X7' in FIG. 21 according to one or more embodiments of the present disclosure;
FIG. 27 is a graph showing a'-b' color difference plots of display devices according to a comparative example and another embodiment of the present disclosure, which were measured by the SCE measurement method;
FIG. 28A is a plan view illustrating a sub-display area of a display device according to one or more embodiments of the present disclosure; and
FIG. 28B is a cross-sectional view taken along the line X8-X8' of FIG. 28A according to one or more embodiments of the present disclosure.

### DETAILED DESCRIPTION

The disclosure will now be described more fully hereinafter with reference to the accompanying drawings, in which one or more embodiments of the present disclosure are shown. This disclosure may, however, be embodied in different forms and should not be construed as limited to one or more embodiments set forth herein. Rather, these embodiments are provided so that this disclosure will be thorough and complete, and will fully convey the scope of the present disclosure to those skilled in the art.

It will be understood that if (e.g., when) a layer is referred to as being "on" another layer or substrate, it may be directly on the other layer or substrate, or one or more intervening layers may also be present. In contrast, "directly on" may refer to that there are no additional intervening elements or layers between the element or layer and the another element or layer. The same or like reference numbers indicate the same or like components throughout the disclosure, and thus duplicative descriptions thereof may not be provided for conciseness.

Hereinafter, embodiments of the present disclosure will be described in more detail with reference to the accompanying drawings.

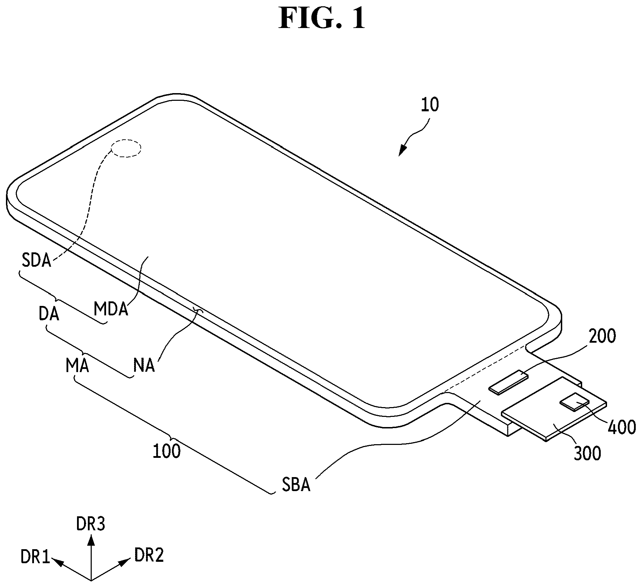

FIG. 1 is a perspective view showing a display device according to one or more embodiments of the present disclosure.

Referring to FIG. 1, a display device 10, which is a device that displays a moving image or a still image, may be used as a display screen of one or more suitable electronic devices, such as a television, a laptop computer, a monitor, a billboard, and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device, and/or an ultra-mobile PC (UMPC).

The display device 10 according to one or more embodiments may be a light emitting display device such as an organic light emitting display device including an organic light emitting diode, a quantum dot light emitting display device including a quantum dot light emitting layer, an inorganic light emitting display device including an inorganic semiconductor, or a micro light emitting display device using a micro or nano light emitting diode (LED). In the following, one or more embodiments in which the display device 10 is an organic light emitting display device will be described, but the type (kind) of display device 10 is not limited thereto.

In one or more embodiments, the display device 10 may be formed flat. For example, the display device 10 may be formed substantially flat on a plane defined by a first direction DR1 and a second direction DR2, and may have a set or predetermined thickness (or height) in a third direction DR3. In one or more embodiments, the display device 10 may include a curved surface in at least a part thereof including an edge region and/or the like. In one or more embodiments, the display device 10 may be formed to be flexible so that it may be curved, bent, folded, or rolled.

In one or more embodiments, with respect to an image display surface of the display device 10, the first direction DR1 may be a lengthwise direction, a column direction, or a vertical direction, and the second direction DR2 may be a direction intersecting the first direction DR1, for example, a widthwise direction, a row direction, or a horizontal direction. The third direction DR3 may be a thickness direction or a height direction of the display device 10.

The display device 10 may include a display panel 100, a driver 200, a circuit board 300, and a touch driver 400.

The display panel 100 may include a main region MA including a display area DA in which an image is displayed, and a sub-region SBA located on a (e.g., one) side of the main region MA.

The main region MA may include the display area DA and a non-display area NA around (e.g., surrounding) the display area DA. The display area DA may be positioned in the center of the main region MA and occupy most of the area in the main region MA. The non-display area NA may be positioned at an edge of the main region MA and may be in contact with the sub-region SBA.

The display area DA may be an area in which pixels are arranged, and may be an area in which an image is displayed by the pixels. In one or more embodiments, the display area DA may be further provided with sensing patterns (e.g., touch electrodes) for detecting a touch input and/or the like, and the display area DA may include a sensing area for detecting a touch input by the sensing patterns.

In one or more embodiments, the display area DA may include a long side in the first direction DR1 and a short side in the second direction DR2 and may be formed as a plane having an approximately rectangular shape. A corner portion at which the long side and the short side of the display area DA meet may be rounded or right-angled. A shape of the display area DA may be variously changed according to one or more embodiments. For example, in one or more embodiments, the display area DA may be formed in a polygonal shape other than a quadrilateral shape, a circular shape, an elliptical shape, and/or the like.

The display area DA may include a main display area MDA and a sub-display area SDA. The sub-display area SDA may be an area where components for adding one or more suitable functions to the display device 10 are arranged, and the sub-display area SDA may correspond to a component area.

The non-display area NA may be located immediately around the display area DA. The non-display area NA may be around (e.g., surround) the display area DA. An embedded circuit may be arranged in the non-display area NA. For example, in one or more embodiments, an embedded circuit including a scan driving circuit and/or the like may be arranged in the non-display area NA positioned on one side (e.g., the left side or the right side) or both sides (e.g., two opposite edge sides) of the display area DA.

The sub-region SBA may be located on a (e.g., one) side of the main region MA. For example, in one or more embodiments, the sub-region SBA may be a region protruding in the first direction DR1 from one side of the main region MA. For example, in one or more embodiments, the sub-region SBA may protrude in the first direction DR1 from a lower end of the main region MA. In one or more embodiments, the sub-region SBA may have a narrower width than the main region MA. For example, with respect to the second direction DR2, the sub-region SBA may have a narrower width than the main region MA.

Wires and pads may be arranged in the sub-region SBA. For example, in the sub-region SBA, the wires and pads connected to the pixels and/or the embedded circuit positioned in the main region MA and to the driver 200 and/or the circuit board 300 positioned in the sub-region SBA may be arranged. In describing embodiments, the term "connect" may include electrical connection and/or physical connection.

In one or more embodiments, the driver 200 (e.g., a display driving circuit) may be mounted in the sub-region SBA. The circuit board 300 may be arranged on a part of the sub-region SBA.

The driver 200 may include a data driving circuit to drive pixels. In one or more embodiments, the driver 200 may be formed as an integrated circuit (IC) chip and arranged in the sub-region SBA. In one or more embodiments, the driver 200 may be arranged on the circuit board 300 on the sub-region SBA or may be arranged on another circuit board connected to the display panel 100 through the circuit board 300.

The circuit board 300 may be arranged on a part of the sub-region SBA. For example, in one or more embodiments, the circuit board 300 may be bonded on the pads positioned on a portion (e.g., a lower edge) of the sub-region SBA, and may supply or transmit power voltages and driving signals for driving the display panel 100 to the display panel 100. For example, the circuit board 300 may supply input image data (e.g., digital image data), driving signals including timing signals, and driving voltages to the display panel 100. The circuit board 300 may be a flexible film such as a flexible printed circuit board (FPCB), a printed circuit board (PCB), and/or a chip on film (COF), but embodiments of the present disclosure are not limited thereto.

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit and may sense an amount of change in capacitance between the plurality of touch electrodes. For example, in one or more embodiments, the touch driving signal may be a pulse signal having a set or predetermined frequency. The touch driver 400 may calculate whether an input is made and input coordinates based on an amount of change in capacitance between the plurality of touch electrodes. The touch driver 400 may be formed as an integrated circuit (IC).

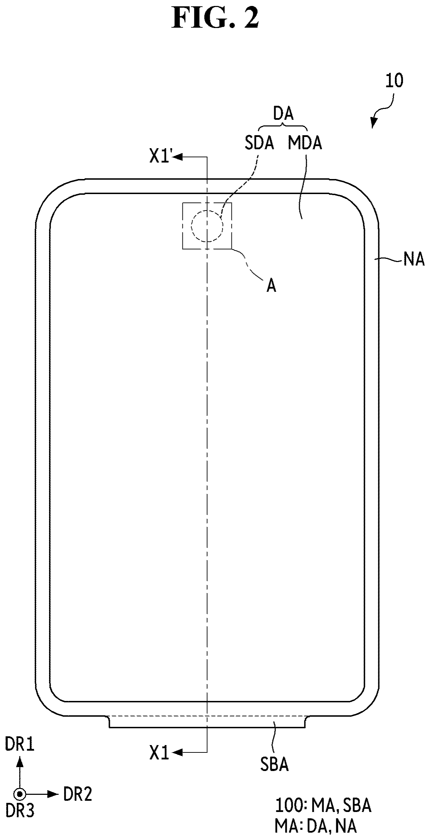

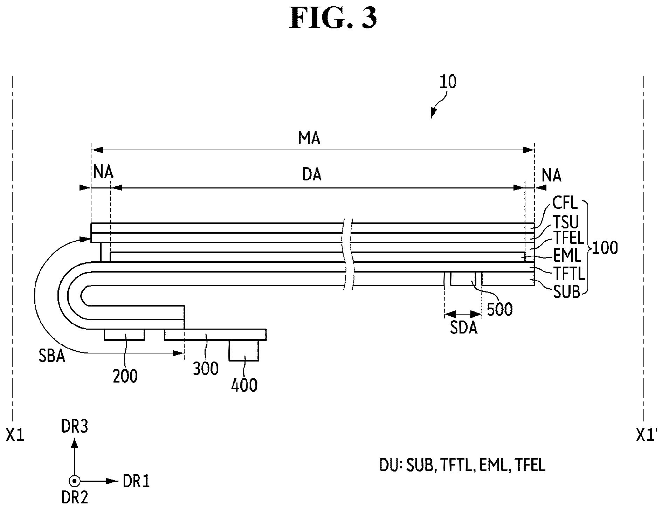

FIG. 2 is a plan view illustrating a display device according to one or more embodiments of the present disclosure. FIG. 3 is a cross-sectional view of the display device taken along the line X1-X1' of FIG. 2 according to one or more embodiments.

FIG. 1 illustrates the display device 10 unfolded without bending, and FIG. 2 and FIG. 3 illustrate the display device 10 bent in the sub-region SBA. FIG. 1 shows a state where the sub-region SBA is unfolded alongside the main region MA, and FIG. 2 and FIG. 3 show a state where a part of the sub-region SBA is bent.

Referring to FIG. 2 and FIG. 3, the display panel 100 may include a substrate SUB including the main region MA and the sub-region SBA, and a circuit layer TFTL, a light emitting element layer EML, an encapsulation layer TFEL, a touch sensing layer TSU, and a color filter layer CFL sequentially arranged on the substrate SUB (e.g., in the stated order). The circuit layer TFTL may also be positioned in the main region MA and the sub-region SBA on the substrate SUB. The light emitting element layer EML and the encapsulation layer TFEL may be positioned on a part of the substrate SUB and the circuit layer TFTL. For example, the light emitting element layer EML and the encapsulation layer TFEL may be positioned in the main region MA.

In one or more embodiments, the display device 10 may further include one or more additional elements arranged on the display panel 100. For example, in one or more embodiments, the display device 10 may further include at least one of a polarization layer or a protective layer (e.g., a window) arranged on the encapsulation layer TFEL. Each of the polarization layer and/or the protective layer may be manufactured integrally with the display panel 100 or may be manufactured separately from the display panel 100 and attached to the display panel 100 through an adhesive layer and/or the like.

The substrate SUB may include an insulating material such as a polymer resin. For example, in one or more embodiments, the substrate SUB may be made of polyimide or another insulating material. The substrate SUB may be a flexible substrate that can be transformed such as bending, folding, or rolling. In one or more embodiments, the substrate SUB may include an insulating material such as glass.

The circuit layer TFTL may include pixel circuits and wires. For example, the circuit layer TFTL may include circuit elements (e.g., pixel transistors and capacitors) constituting a pixel circuit for each pixel, and wires connected to the pixels. In one or more embodiments, the circuit layer TFTL may further include circuit elements constituting an embedded circuit, such as a scan driving circuit, and wires connected to the embedded circuit.

The light emitting element layer EML may include light emitting elements arranged in emission areas of the pixels. For example, each of the pixels may include at least one light emitting element and a pixel circuit connected to the light emitting element. Each of the pixels may be located in a pixel region including the emission area where the light emitting element is arranged and a pixel circuit area where the pixel circuit is arranged. The emission area and the pixel circuit area of each pixel may overlap each other, but embodiments of the present disclosure are not limited thereto.

In describing embodiments of the disclosure, the circuit layer TFTL and the light emitting element layer EML are separately described, but embodiments of the present disclosure are not limited thereto. For example, in one or more embodiments, the circuit layer TFTL and the light emitting element layer EML may be integrated.

The encapsulation layer TFEL may cover the light emitting element layer EML and may extend to the non-display area NA to be in contact with the circuit layer TFTL. In one or more embodiments, the encapsulation layer TFEL may have a multilayer structure including at least two inorganic encapsulation layers overlapping each other and at least one organic encapsulation layer interposed between the inorganic encapsulation layers.

The touch sensing layer TSU may be arranged on the encapsulation layer TFEL. In one or more embodiments, the touch sensing layer TSU may include a plurality of touch electrodes for sensing a user's touch in a capacitive manner, and touch lines connecting the plurality of touch electrodes to the touch driver 400. For example, the touch sensing layer TSU may sense the user's touch by using a mutual capacitance method or a self-capacitance method.

In one or more embodiments, the touch sensing layer TSU may be arranged on a separate substrate arranged on the display panel 100. In these embodiments, the substrate supporting the touch sensing layer TSU may be a base member that encapsulates the display panel 100.

The plurality of touch electrodes of the touch sensing layer TSU may be arranged in a touch sensor area overlapping the display area DA. The touch lines of the touch sensing layer TSU may be arranged in a touch peripheral area that overlaps the non-display area NA.

In one or more embodiments, the display device 10 may further include an optical device 500. The optical device 500 may be arranged in the sub-display area SDA. The optical device 500 may be to emit or receive light in infrared, ultraviolet, and/or visible light bands. For example, in one or more embodiments, the optical device 500 may be an optical sensor that detects light incident on the display device 10, such as a proximity sensor, an illuminance sensor, and/or a camera sensor or an image sensor.

The color filter layer CFL may be arranged on the touch sensing layer TSU. The color filter layer CFL may include a plurality of color filters respectively corresponding to the plurality of emission areas. Each of the color filters may selectively transmit light of a specific wavelength and may block or absorb light of a different wavelength. The color filter layer CFL may be to absorb a part of light coming from the outside of the display device 10 to reduce reflected light due to external light. Accordingly, the color filter layer CFL may prevent or reduce color distortion caused by reflection of the external light.

Because the color filter layer CFL is directly arranged on the touch sensing layer TSU, the display device 10 may not require a separate substrate for the color filter layer CFL. Accordingly, the thickness of the display panel 100 may be relatively small.

In one or more embodiments, the display panel 100 may be bent in a bending area. The bending area may be a part of the sub-region SBA and may be spaced and/or apart (e.g., spaced apart or separated) from the main region MA.

The substrate SUB and the circuit layer TFTL may be bent in the bending area corresponding to a partial section of the sub-region SBA. Accordingly, a bezel area recognized by a user as the non-display area NA may be reduced or minimized.

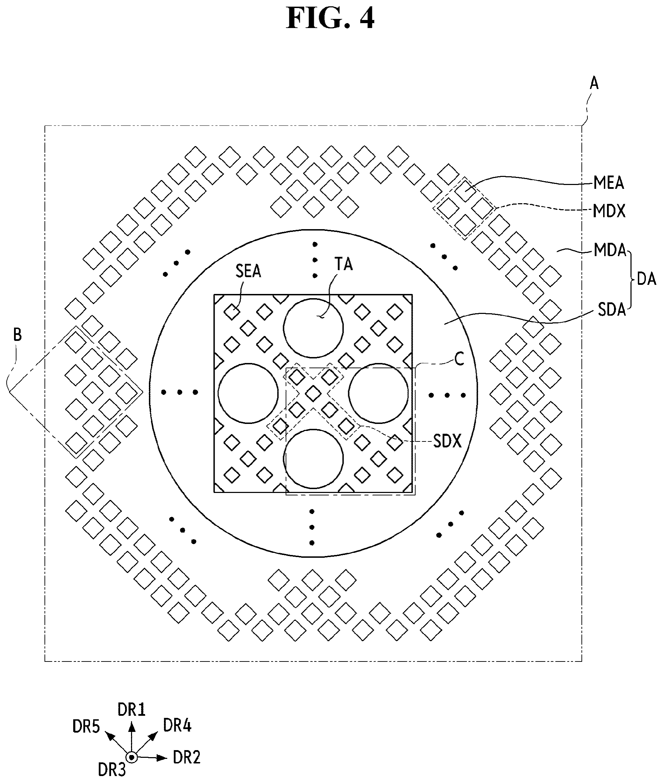

FIG. 4 is an enlarged view of area A of FIG. 2 according to one or more embodiments of the present disclosure. FIG. 4 shows an arrangement of pixels MDX and SDX in the sub-display area SDA and the main display area MDA arranged around the sub-display area SDA in the display area DA of the display device 10.

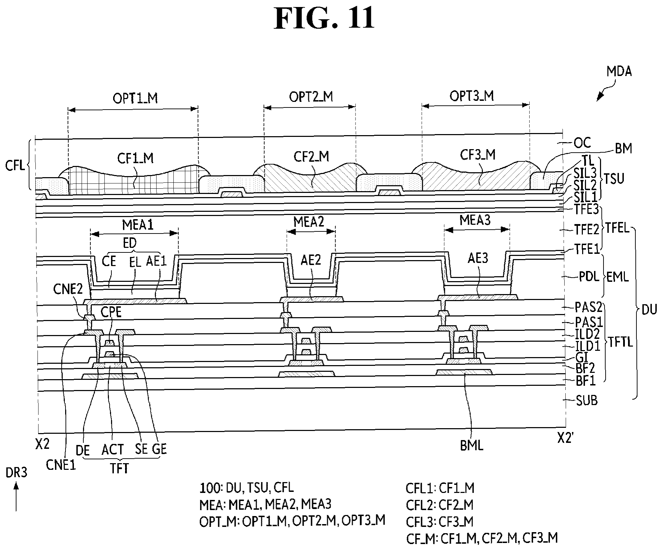

Referring to FIG. 4, the display area DA may include the main display area MDA and the sub-display area SDA. The sub-display area SDA may be an area where components are arranged under the substrate SUB of the display device 10. A plurality of main display pixels MDX may be arranged in the main display area MDA, and a plurality of sub-display pixels SDX may be arranged in the sub-display area SDA. Each of the main display pixels MDX may include one or more main emission areas MEA, and each of the sub- display pixels SDX may include one or more sub-emission areas SEA. A light emitting element ED (see FIG. 11) may be arranged in each of the emission areas MEA and SEA to emit light.

A plurality of light emitting elements ED (see FIG. 11) that emit light, and pixel circuits that are electrically connected to the light emitting element ED (see FIG. 11) and apply a signal for emission of the light emitting element ED (see FIG. 11) may be arranged in the main display area MDA. The main display area MDA may be an area where the light emitting elements ED (see FIG. 11) and the pixel circuits are arranged in a specific arrangement. In the main display area MDA, each of the light emitting elements ED (see FIG. 11) may constitute one main emission area MEA, and a plurality of main emission areas MEA may constitute one main display pixel MDX. For example, in one or more embodiments, four main emission areas MEA may constitute one main display pixel MDX. For example, one main display pixel MDX may include four main emission areas MEA, and the four main emission areas MEA may constitute one main display pixel MDX to express a white grayscale. The number of main emission areas MEA included in the main display pixel MDX is not limited thereto.

In one or more embodiments, the plurality of main display pixels MDX arranged in the main display area MDA may be arranged in a fourth direction DR4 and a fifth direction DR5, which are diagonal directions between the first direction DR1 and the second direction DR2. Further, the plurality of main emission areas MEA of the main display pixels MDX may be arranged in the fourth direction DR4 and the fifth direction DR5.

The light emitting elements ED (see FIG. 11) that emit light may also be arranged in the sub-display area SDA to constitute the sub-emission area SEA, and a plurality of sub-emission areas SEA may constitute one sub-display pixel SDX. However, the sub-display area SDA may be an area that overlaps a component, for example, the optical device 500, arranged on a back surface of the substrate SUB of the display panel 100, and may have a structure in which transmittance of light is considered, unlike the main display area MDA.

The sub-display pixel SDX formed by a plurality of sub-emission areas SEA of the sub-display area SDA may have an arrangement different from that of the main display pixel MDX. For example, in one or more embodiments, the main display pixel MDX may include four main emission areas MEA, whereas the sub-display pixel SDX may include seven sub-emission areas SEA. The four main emission areas MEA of the main display pixel MDX may correspond to four pixel circuits, respectively. In contrast, two or more sub-emission areas SEA of the sub-display pixel SDX may correspond to one pixel circuit. For example, in one or more embodiments, the sub-display pixel SDX may include seven sub-emission areas SEA that emit light by three pixel circuits. Accordingly, the luminance and resolution of the sub-display area SDA may be different from those of the main display area MDA.

In one or more embodiments, the plurality of sub-display pixels SDX arranged in the sub-display area SDA may be arranged in the fourth direction DR4 and the fifth direction DR5, which are diagonal directions between the first direction DR1 and the second direction DR2. Further, the plurality of sub-emission areas SEA of the sub-display pixels SDX may be arranged in the fourth direction DR4 and the fifth direction DR5.

The sub-display area SDA may further include transmission areas TA that transmit light. The transmission area TA is an area through which light incident on the display panel 100 passes.

The transmission area TA may be arranged adjacent to the sub-emission areas SEA. The transmission area TA may not overlap the sub-emission areas SEA. The transmission area TA may be surrounded by the sub-emission areas SEA.

The plurality of transmission areas TA may be arranged in the first direction DR1 and the second direction DR2. The sub-emission areas SEA may be arranged not only between the first direction DR1 and the second direction DR2 of the plurality of transmission areas TA, but also between the fourth direction DR4 and the fifth direction DR5 thereof.

Due to the transmission areas TA, the number of sub-emission areas SEA per unit area in the sub-display area SDA may be different from the number of main emission areas MEA per unit area in the main display area MDA. For example, in one or more embodiments, the number of sub-emission areas SEA per unit area in the sub-display area SDA may be smaller than the number of main emission areas MEA per unit area in the main display area MDA.

In addition, a ratio of the area of the sub-emission areas SEA of the sub-display area SDA to the area of the sub-display area SDA may be different from a ratio of the area of the main emission areas MEA of the main display area MDA to the area of the main display area MDA, due to the transmission areas TA. For example, in one or more embodiments, the ratio of the area of the sub-emission areas SEA of the sub-display area SDA to the area of the sub-display area SDA may be smaller than the ratio of the area of the main emission areas MEA of the main display area MDA to the area of the main display area MDA.

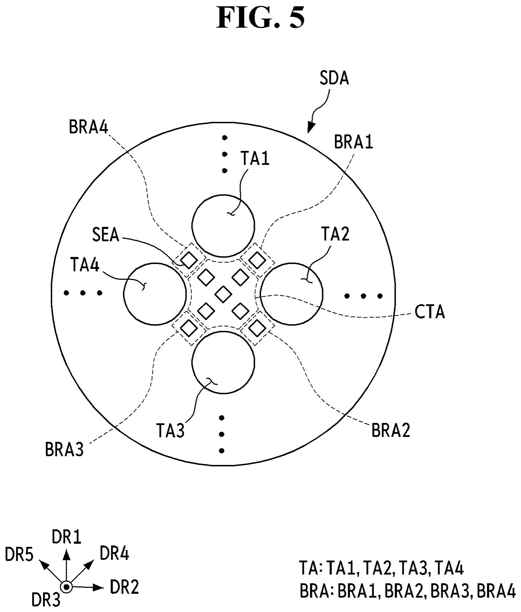

Hereinafter, the sub-display area SDA will be described in more detail with reference to FIG. 5.

FIG. 5 is a plan view illustrating a sub-display area according to one or more embodiments of the present disclosure.

Referring to FIG. 5 in addition to FIG. 4, the sub-display area SDA may include a central area CTA, a bridge area BRA, and the transmission area TA.

In one or more embodiments, the transmission area TA may include a first transmission area TA1, a second transmission area TA2, a third transmission area TA3, and a fourth transmission area TA4. The first transmission area TA1 and the third transmission area TA3 may be arranged in the first direction DR1, and the second transmission area TA2 and the fourth transmission area TA4 may be arranged in the second direction DR2. The first transmission area TA1 and the second transmission area TA2 may be arranged in the fifth direction DR5, and the first transmission area TA1 and the fourth transmission area TA4 may be arranged in the fourth direction DR4. The third transmission area TA3 and the second transmission area TA2 may be arranged in the fourth direction DR4, and the third transmission area TA3 and the fourth transmission area TA4 may be arranged in the fifth direction DR5. The first to fourth transmission areas TA1, TA2, TA3, and TA4 may be sequentially arranged in a clockwise direction.

The central area CTA, which is an area surrounded by the first to fourth transmission areas TA1, TA2, TA3, and TA4, may be positioned between the first transmission area TA1 and the third transmission area TA3 in the first direction DR1, and may be positioned between the second transmission area TA2 and the fourth transmission area TA4 in the second direction DR2.

The bridge area BRA may be an area except the central area CTA in the area located between the transmission areas TA. For example, the bridge area BRA may be an area positioned between the transmission areas TA in the fourth direction DR4 and the fifth direction DR5.

The bridge area BRA may include a first bridge area BRA1, a second bridge area BRA2, a third bridge area BRA3, and a fourth bridge area BRA4. The first bridge area BRA1 may be positioned between the first transmission area TA1 and the second transmission area TA2 in the fifth direction DR5. The second bridge area BRA2 may be positioned between the second transmission area TA2 and the third transmission area TA3 in the fourth direction DR4. The third bridge area BRA3 may be positioned between the third transmission area TA3 and the fourth transmission area TA4 in the fifth direction DR5. The fourth bridge area BRA4 may be positioned between the fourth transmission area TA4 and the first transmission area TA1 in the fourth direction DR4. The first to fourth bridge areas BRA1, BRA2, BRA3, and BRA4 may be sequentially arranged in a clockwise direction.

The first bridge area BRA1 and the second bridge area BRA2 may be arranged in the first direction DR1, the second bridge area BRA2 and the third bridge area BRA3 may be arranged in the second direction DR2, the third bridge area BRA3 and the fourth bridge area BRA4 may be arranged in the first direction DR1, and the fourth bridge area BRA4 and the first bridge area BRA1 may be arranged in the second direction DR2.

The sub-emission area SEA may be arranged in the central area CTA and the bridge area BRA. For example, as illustrated in FIG. 5, in one or more embodiments, five sub-emission areas SEA may be arranged in each central area CTA, and one sub-emission area SEA may be arranged in each bridge area BRA. However, the number of sub-emission areas SEA arranged in the central area CTA and the bridge area BRA is not limited thereto.

In one or more embodiments, the sub-display pixel SDX may include the sub-emission area SEA arranged in the central area CTA and the sub-emission area SEA arranged in the bridge area BRA. For example, as illustrated in FIG. 4 and FIG. 5, in one or more embodiments, the sub-display pixel SDX may include the sub-emission areas SEA that are arranged in the central area CTA, the second bridge area BRA2, and the third bridge area BRA3.

In the display device 10 according to the present embodiments, the sub-emission area SEA is arranged not only in the central area CTA but also in the bridge area BRA, thereby increasing the resolution in the sub-display area SDA. Accordingly, the resolution difference between the main display area MDA and the sub-display area SDA may be minimized or reduced.

Hereinafter, the arrangement and structure of the pixels MDX and SDX in the main display area MDA and the sub-display area SDA, respectively, of the display device 10 will be described in more detail with further reference to other drawings.

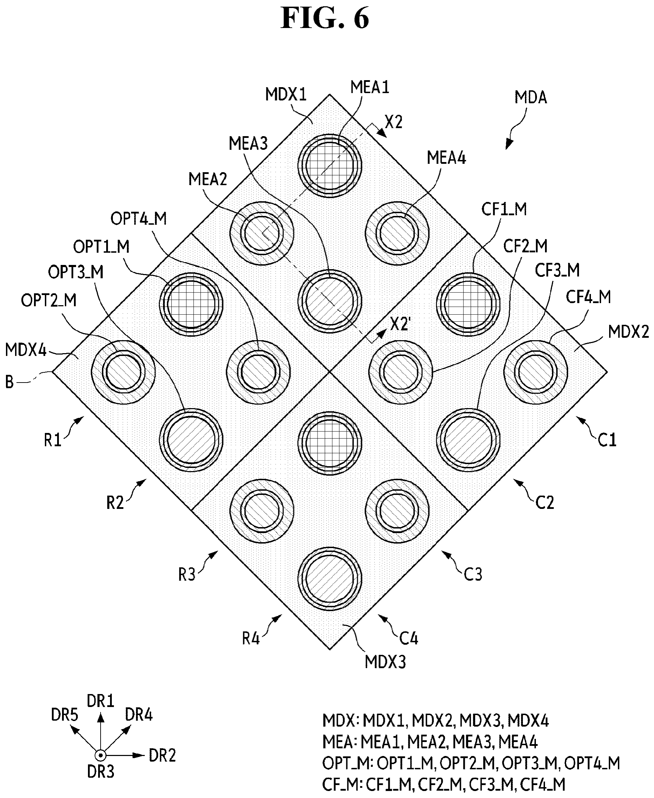

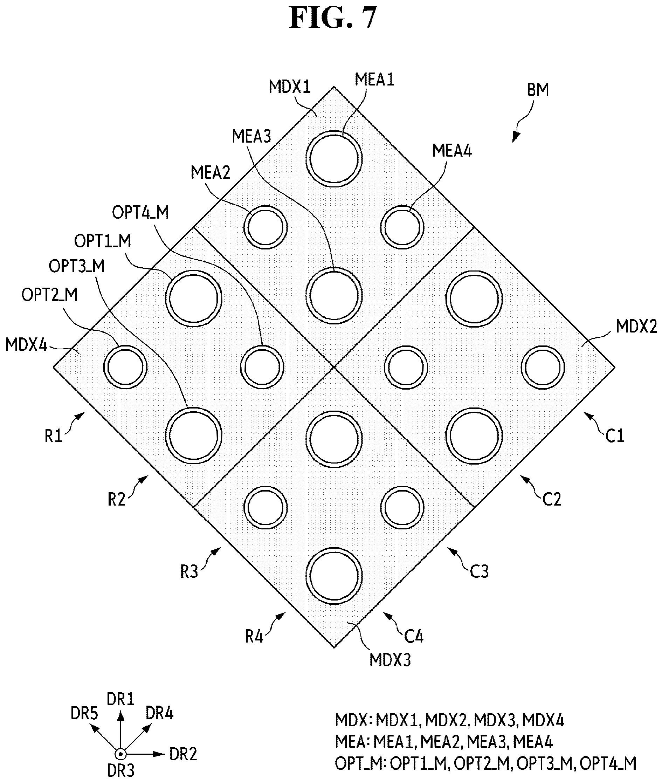

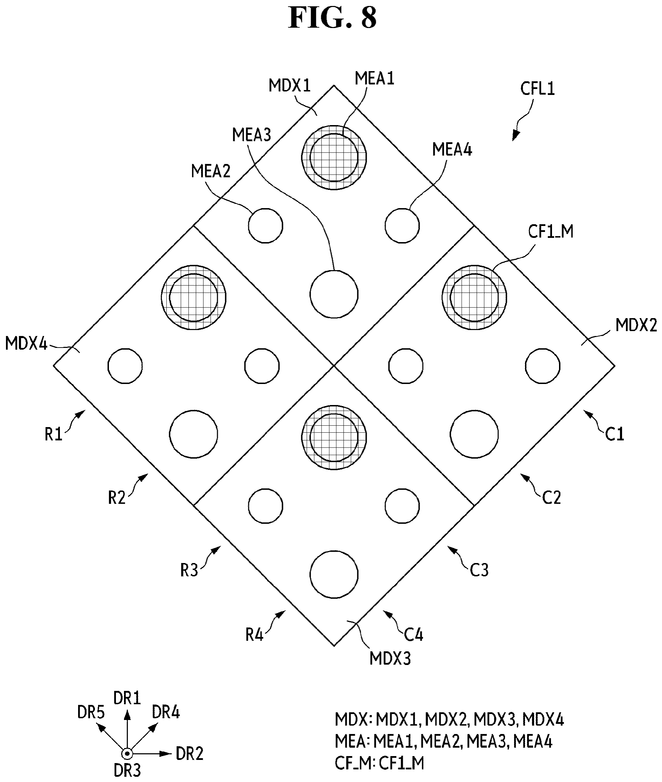

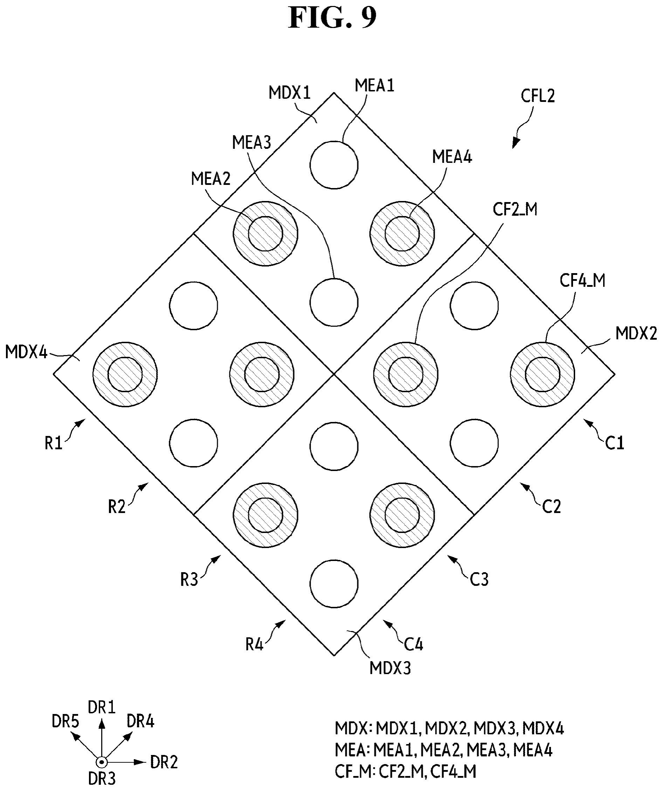

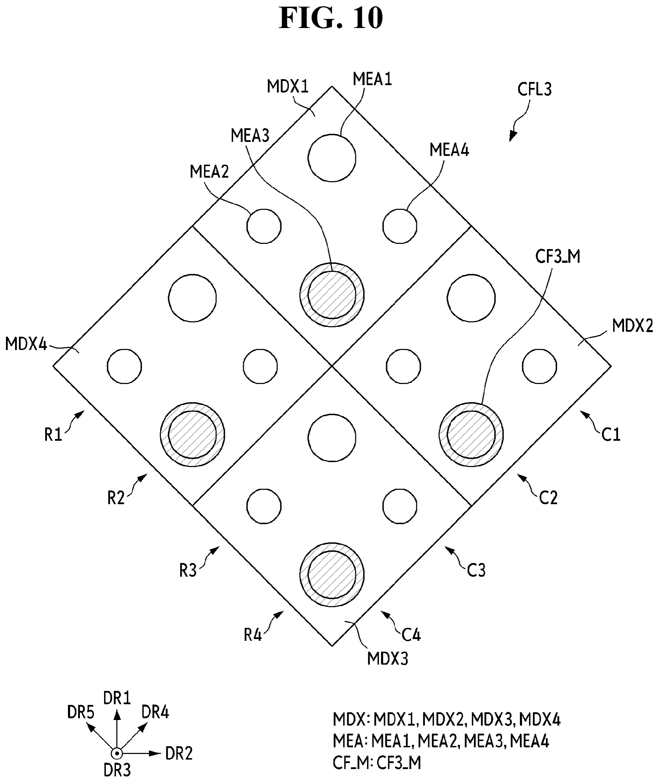

FIG. 6 is a layout diagram showing a light blocking layer, a first color filter layer, a second color filter layer, and a third color filter layer in a first main pixel according to one or more embodiments of the present disclosure. FIG. 7 is a layout diagram showing a light blocking layer in a first main pixel according to one or more embodiments. FIG. 8 is a layout diagram showing a first color filter layer in a first main pixel according to one or more embodiments. FIG. 9 is a layout diagram showing a second color filter layer in a first main pixel according to one or more embodiments. FIG. 10 is a layout diagram showing a third color filter layer in a first main pixel according to one or more embodiments.

Referring to FIGS. 6 to 10, the main display area MDA may include a plurality of main display pixels MDX. For example, the main display area MDA may include a first main display pixel MDX1, a second main display pixel MDX2, a third main display pixel MDX3, and a fourth main display pixel MDX4.

The plurality of main display pixels MDX may be arranged in the fourth direction DR4 and the fifth direction DR5. For example, the first main display pixel MDX1 and the second main display pixel MDX2 may be arranged in the fifth direction DR5, the second main display pixel MDX2 and the third main display pixel MDX3 may be arranged in the fourth direction DR4, the third main display pixel MDX3 and the fourth main display pixel MDX4 may be arranged in the fifth direction DR5, and the fourth main display pixel MDX4 and the first main display pixel MDX1 may be arranged in the fourth direction DR4. The first to fourth main display pixels MDX1, MDX2, MDX3, and MDX4 may be repeatedly arranged in the arrangement of FIG. 6 over the entire main display area MDA.

Each of the plurality of main display pixels MDX may include a plurality of main emission areas MEA. For example, each of the plurality of main display pixels MDX may include a first main emission area MEA1, a second main emission area MEA2, a third main emission area MEA3, and a fourth main emission area MEA4. However, the number of main emission areas MEA included in the main display pixel MDX is not limited thereto, and may be variously changed. In one or more embodiments, the first main emission area MEA1, the second main emission area MEA2, the third main emission area MEA3, and the fourth main emission area MEA4 may be arranged in a same arrangement in each of the plurality of main display pixels MDX.

One main display pixel MDX may include one or more light emitting elements ED (see FIG. 11). One or more light emitting elements ED (see FIG. 11) included in one main display pixel MDX may be to emit light of the same color or different colors. For example, in one or more embodiments, the light emitting element ED (see FIG. 11) arranged in the first main emission area MEA1 may be to emit first light of a red color, the light emitting element ED (see FIG. 11) arranged in the second main emission area MEA2 may be to emit second light of a green color, and the light emitting element ED (see FIG. 11) arranged in the third main emission area MEA3 may be to emit third light of a blue color. The light emitting element ED (see FIG. 11) arranged in the fourth main emission area MEA4 may be to emit the second light of the green color, but embodiments of the present disclosure are not limited thereto.

The main emission area MEA may be an area where a light emitting layer EL (see FIG. 11) overlaps respective pixel electrodes AE1, AE2, and AE3 (see FIG. 11). For example, an opening of a pixel defining film PDL (see FIG. 11) may correspond to the main emission area MEA. For example, the main emission areas MEA may be respectively defined by a plurality of openings of the pixel defining film PDL (see FIG. 11) of a light emitting element layer EML (see FIG. 11).

The first main emission area MEA1 may be defined by a first opening of the pixel defining film PDL (see FIG. 11) that overlaps a first pixel electrode AE1 (see FIG. 11), the second main emission area MEA2 may be defined by a second opening of the pixel defining film PDL (see FIG. 11) that overlaps a second pixel electrode AE2 (see FIG. 11), and the third main emission area MEA3 may be defined by a third opening of the pixel defining film PDL (see FIG. 11) that overlaps a third pixel electrode AE3 (see FIG. 11). Although not shown in FIG. 11, the fourth main emission area MEA4 may be defined by a fourth opening of the pixel defining film PDL (see FIG. 11) that overlaps a fourth pixel electrode.

The plurality of main emission areas MEA may be arranged in a PenTile^{®} type (kind), e.g., a diamond PenTile^{®} type (kind). PenTile^{®} is a duly registered trademark of Samsung Display Co., Ltd. For example, the first main emission area MEA1 and the third main emission area MEA3 may be spaced and/or apart (e.g., spaced apart or separated) from each other in the first direction DR1, and may be alternately and repeatedly arranged in the first direction DR1 and the second direction DR2. The second main emission area MEA2 and the fourth main emission area MEA4 may be spaced and/or apart (e.g., spaced apart or separated) from each other in the second direction DR2. The second main emission area MEA2 and the fourth main emission area MEA4 may be spaced and/or apart (e.g., spaced apart or separated) from the first main emission area MEA1 and the third main emission area MEA3, which are adjacent thereto, in the fourth direction DR4 or the fifth direction DR5. The second main emission area MEA2 and the fourth main emission area MEA4 may be alternately and repeatedly arranged along the first direction DR1 and the second direction DR2, and the second main emission area MEA2 and the first main emission area MEA1, or the fourth main emission area MEA4 and the third main emission area MEA3 may be alternately and repeatedly arranged along the fourth direction DR4 or the fifth direction DR5.

In a first diagonal column C1, the first main emission area MEA1 and the fourth main emission area MEA4 of the first main display pixel MDX1 and the first main emission area MEA1 and the fourth main emission area MEA4 of the second main display pixel MDX2 may be arranged in the fifth direction DR5. In a second diagonal column C2, the second main emission area MEA2 and the third main emission area MEA3 of the first main display pixel MDX1 and the second main emission area MEA2 and the third main emission area MEA3 of the second main display pixel MDX2 may be arranged in the fifth direction DR5. In a third diagonal column C3, the first main emission area MEA1 and the fourth main emission area MEA4 of the fourth main display pixel MDX4 and the first main emission area MEA1 and the fourth main emission area MEA4 of the third main display pixel MDX3 may be arranged in the fifth direction DR5. In a fourth diagonal column C4, the second main emission area MEA2 and the third main emission area MEA3 of the fourth main display pixel MDX4 and the second main emission area MEA2 and the third main emission area MEA3 of the third main display pixel MDX3 may be arranged in the fifth direction DR5.

In a first diagonal row R1, the first main emission area MEA1 and the second main emission area MEA2 of the first main display pixel MDX1 and the first main emission area MEA1 and the second main emission area MEA2 of the fourth main display pixel MDX4 may be arranged in the fourth direction DR4. In a second diagonal row R2, the fourth main emission area MEA4 and the third main emission area MEA3 of the first main display pixel MDX1 and the fourth main emission area MEA4 and the third main emission area MEA3 of the fourth main display pixel MDX4 may be arranged in the fourth direction DR4. In a third diagonal row R3, the first main emission area MEA1 and the second main emission area MEA2 of the second main display pixel MDX2 and the first main emission area MEA1 and the second main emission area MEA2 of the third main display pixel MDX3 may be arranged in the fourth direction DR4. In a fourth diagonal row R4, the fourth main emission area MEA4 and the third main emission area MEA3 of the second main display pixel MDX2 and the fourth main emission area MEA4 and the third main emission area MEA3 of the third main display pixel MDX3 may be arranged in the fourth direction DR4.

In one or more embodiments, the areas or sizes of the first to fourth main emission areas MEA1, MEA2, MEA3, and MEA4 may be different from one another. In one or more embodiments of FIG. 6, the area of the first main emission area MEA1 may be larger than the area of each of the second main emission area MEA2, the third main emission area MEA3, and the fourth main emission area MEA4, and the area of the third main emission area MEA3 may be larger than the area of each of the second main emission area MEA2 and the fourth main emission area MEA4. The intensity of emitted light may vary depending on the area of each main emission area MEA, and the color of the screen displayed on the display device 10 may be controlled or selected by adjusting the area of each main emission area MEA. In one or more embodiments of FIG. 6, the first main emission area MEA1 having the largest area is illustrated, but embodiments of the present disclosure are not limited thereto. Depending on the color of the screen desired or required for the display device 10, the size of each main emission area MEA and the area of the emission area may be freely and suitably adjusted. In addition, the area of each main emission area MEA may be related to light efficiency, the lifespan of the light emitting element ED (see FIG. 11), and/or the like, and may have a trade-off relationship with the reflection by external light. The area of each main emission area MEA may be adjusted in consideration of the above factors.

Although it is illustrated in the drawing that each of the main emission areas MEA of one or more embodiments has a circular planar shape, embodiments of the present disclosure are not limited thereto.

The display device 10 may include a light blocking layer BM, and a first color filter layer CFL1, a second color filter layer CFL2, and a third color filter layer CFL3 that are arranged on the light blocking layer BM.

The light blocking layer BM may be arranged over the entire display area DA. For example, the light blocking layer BM may be arranged over the main display area MDA and the sub-display area SDA.

The light blocking layer BM may include a plurality of main openings OPT_M arranged in the main display area MDA and arranged to respectively correspond to the main emission areas MEA. The light blocking layer BM may cover the main display area MDA except the area where the plurality of main openings OPT_M are arranged in the main display area MDA. The plurality of main openings OPT_M of the light blocking layer BM may be areas where light emitted from the light emitting elements ED (see FIG. 11) corresponding to the main emission areas MEA is emitted.

The plurality of main openings OPT_M may include a first main opening OPT1_M overlapping the first main emission areas MEA1, a second main opening OPT2_M overlapping the second main emission areas MEA2, a third main opening OPT3_M overlapping the third main emission areas MEA3, and a fourth main opening OPT4_M overlapping the fourth main emission areas MEA4.

A planar area of each of the plurality of main openings OPT_M may be larger than a planar area of each corresponding main emission area MEA. For example, the planar area of the first main opening OPT1_M may be larger than that of the first main emission area MEA1, the planar area of the second main opening OPT2_M may be larger than that of the second main emission area MEA2, the planar area of the third main opening OPT3_M may be larger than that of the third main emission area MEA3, and the planar area of the fourth main opening OPT4_M may be larger than that of the fourth main emission area MEA4. In the disclosure, the terms "planar area," "planar size," and "area" or "size" of an element may refer to the projected area of the element on a plane defined by the first direction DR1 and the second direction DR2. For example, when the disclosure mentions the "planar area" or "size" of an element, it is referring to the size of the element as it would appear if one would looked at it from above, flattened onto a surface defined by two specific directions (DR1 and DR2).

The first color filter layer CFL1 may be arranged on the light blocking layer BM. The second color filter layer CFL2 may be arranged on the first color filter layer CFL1. The third color filter layer CFL3 may be arranged on the second color filter layer CFL2.

The first color filter layer CFL1 may include a first main color portion CF1_M arranged in the main display area MDA, the second color filter layer CFL2 may include a second main color portion CF2_M and a fourth main color portion CF4_M arranged in the main display area MDA, and the third color filter layer CFL3 may include a third main color portion CF3_M arranged in the main display area MDA. The first to fourth main color portions CF1_M, CF2_M, CF3_M, and CF4_M may be included in a main color portion CF_M.

The main color portion CF_M may contain a colorant, such as a dye and/or a pigment, that absorbs light in a wavelength band other than a specific wavelength band, and may be arranged to correspond to the color of the light emitted by the light emitting element ED (see FIG. 11). For example, in one or more embodiments, the first main color portion CF1_M may be a red color filter transmitting only the first light of the red color and arranged to overlap the first main emission area MEA1. The second main color portion CF2_M may be a green color filter transmitting only the second light of the green color and arranged to overlap the second main emission area MEA2. The third main color portion CF3_M may be a blue color filter transmitting only the third light of the blue color and arranged to overlap the third main emission area MEA3, and the fourth main color portion CF4_M may be a green color filter transmitting only the second light of the green color and arranged to overlap the fourth main emission area MEA4.

The plurality of main color portions CF_M may be arranged to correspond to the plurality of main emission areas MEA, respectively. For example, in one or more embodiments, the first main color portion CF1_M may be arranged to overlap the first main emission area MEA1, the second main color portion CF2_M may be arranged to overlap the second main emission area MEA2, the third main color portion CF3_M may be arranged to overlap the third main emission area MEA3, and the fourth main color portion CF4_M may be arranged to overlap the fourth main emission area MEA4.

Similarly to the arrangement of the main emission areas MEA, the main color portions CF_M may be arranged in a PenTile^{®} type (kind), e.g., a diamond PenTile^{®} type (kind). For example, the first main color portion CF1_M and the third main color portion CF3_M may be spaced and/or apart (e.g., spaced apart or separated) from each other in the first direction DR1, and may be alternately and repeatedly arranged in the first direction DR1 and the second direction DR2. The second main color portion CF2_M and the fourth main color portion CF4_M may be spaced and/or apart (e.g., spaced apart or separated) from each other in the second direction DR2. The second main color portion CF2_M and the fourth main color portion CF4_M may be spaced and/or apart (e.g., spaced apart or separated) from the first main color portion CF1_M and third main color portion CF3_M, which are adjacent thereto, in the fourth direction DR4 or the fifth direction DR5. The second main color portion CF2_M and the fourth main color portion CF4_M may be alternately and repeatedly arranged along the first direction DR1 and the second direction DR2, and the second main color portion CF2_M and the first main color portion CF1_M, or the fourth main color portion CF4_M and the third main color portion CF3_M may be alternately and repeatedly arranged along the fourth direction DR4 or the fifth direction DR5.

The planar sizes or areas of the plurality of main color portions CF_M may be different from one another. As described above, the sizes or areas of the plurality of main emission areas MEA may be different from one another, so that the planar sizes or areas of the plurality of main color portions CF_M may also be different from one another. For example, in one or more embodiments, the size or area of the first main color portion CF1_M may be larger than the size or area of each of the second main color portion CF2_M, the third main color portion CF3_M, and the fourth main color portion CF4_M. Further, the size or area of the third main color portion CF3_M may be larger than the size or area of each of the second main color portion CF2_M and the fourth main color portion CF4_M.

The planar area of each of the plurality of main color portions CF_M may be larger than the planar area of each corresponding main emission area MEA. For example, the planar area of the first main color portion CF1_M may be larger than that of the first main emission area MEA1, the planar area of the second main color portion CF2_M may be larger than that of the second main emission area MEA2, the planar area of the third main color portion CF3_M may be larger than that of the third main emission area MEA3, and the planar area of the fourth main color portion CF4_M may be larger than that of the fourth main emission area MEA4.

The plurality of main color portions CF_M may be arranged to correspond to the plurality of main openings OPT_M of the light blocking layer BM, respectively. For example, the first main color portion CF1_M may be arranged to overlap the first main opening OPT1_M of the light blocking layer BM, the second main color portion CF2_M may be arranged to overlap the second main opening OPT2_M of the light blocking layer BM, the third main color portion CF3_M may be arranged to overlap the third main opening OPT3_M of the light blocking layer BM, and the fourth main color portion CF4_M may be arranged to overlap the fourth main opening OPT4_M of the light blocking layer BM.

The planar area of each of the plurality of main color portions CF_M may be larger than the planar area of each corresponding main opening OPT_M of the light blocking layer BM. For example, the planar area of the first main color portion CF1_M may be larger than that of the first main opening OPT1_M of the light blocking layer BM, the planar area of the second main color portion CF2_M may be larger than that of the second main opening OPT2_M of the light blocking layer BM, the planar area of the third main color portion CF3_M may be larger than that of the third main opening OPT3_M of the light blocking layer BM, and the planar area of the fourth main color portion CF4_M may be larger than that of the fourth main opening OPT4_M of the light blocking layer BM. Accordingly, the plurality of main color portions CF_M may respectively completely cover the main openings OPT_M of the light blocking layer BM.

Although it is illustrated in the drawing that each of the main color portions CF_M of one or more embodiments has a planar circular shape, embodiments of the present disclosure are not limited thereto.

FIG. 11 is a cross-sectional view taken along the line X2-X2' of FIG. 6 according one or more embodiments. FIG. 11 illustrates a cross-section across the first to third main emission areas MEA1, MEA2, and MEA3 of the first main display pixel MDX1 in the main display area MDA. The fourth main emission area MEA4 has substantially the same structure as that of the second main emission area MEA2, and thus is omitted.

Referring to FIG. 11 in addition to FIGS. 6 to 10, the display panel 100 of the display device 10 may include a display layer DU, the touch sensing layer TSU, and the color filter layer CFL. The display layer DU may include the substrate SUB, a thin film transistor layer TFTL, the light emitting element layer EML, and the encapsulation layer TFEL.

The substrate SUB may be a base substrate or a base member. The substrate SUB may be a flexible substrate which may be bent, folded or rolled. For example, in one or more embodiments, the substrate SUB may include a polymer resin such as polyimide, but embodiments of the present disclosure are not limited thereto. In one or more embodiments, the substrate SUB may include a glass material or a metal material.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be arranged on the substrate SUB. The first buffer layer BF1 may include an inorganic film capable of preventing or reducing penetration of air and/or moisture. For example, in one or more embodiments, the first buffer layer BF1 may include a plurality of inorganic films alternately stacked.

The lower metal layer BML may be arranged on the first buffer layer BF1. For example, the lower metal layer BML may be formed as a single layer or multiple layers made of any one selected from among molybdenum (Mo), aluminium (Al), chromium (Cr), gold (Au), titanium (Ti), nickel (Ni), neodymium (Nd), and copper (Cu), or an alloy thereof.

The second buffer layer BF2 may cover the first buffer layer BF1 and the lower metal layer BML. The second buffer layer BF2 may include an inorganic film capable of preventing or reducing penetration of air and/or moisture. For example, in one or more embodiments, the second buffer layer BF2 may include a plurality of inorganic films alternately stacked.

The thin film transistor TFT may be arranged on the second buffer layer BF2, and may constitute a pixel circuit of each of a plurality of pixels. For example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be arranged on the second buffer layer BF2. The semiconductor layer ACT may overlap the lower metal layer BML and the gate electrode GE in the thickness direction, and may be insulated from the gate electrode GE by the gate insulating layer GI. In a part of the semiconductor layer ACT, a material of the semiconductor layer ACT may be made into a conductor to form the source electrode SE and the drain electrode DE.

The gate electrode GE may be arranged on the gate insulating layer GI. The gate electrode GE may overlap the semiconductor layer ACT with the gate insulating layer GI interposed therebetween.

The gate insulating layer GI may be arranged on the semiconductor layer ACT. For example, the gate insulating layer GI may cover the semiconductor layer ACT and the second buffer layer BF2 to insulate the gate electrode GE from the semiconductor layer ACT. The gate insulating layer GI may include a contact hole through which the first connection electrode CNE1 passes.

The first interlayer insulating layer ILD1 may cover the gate electrode GE and the gate insulating layer GI. The first interlayer insulating layer ILD1 may include a contact hole through which the first connection electrode CNE1 passes. The contact hole of the first interlayer insulating layer ILD1 may be connected to the contact hole of the gate insulating layer GI and a contact hole of the second interlayer insulating layer ILD2.

The capacitor electrode CPE may be arranged on the first interlayer insulating layer ILD1. The capacitor electrode CPE may overlap the gate electrode GE in the thickness direction. The capacitor electrode CPE and the gate electrode GE may form a capacitor.

The second interlayer insulating layer ILD2 may cover the capacitor electrode CPE and the first interlayer insulating layer ILD1. The second interlayer insulating layer ILD2 may include a contact hole through which the first connection electrode CNE1 passes. The contact hole of the second interlayer insulating layer ILD2 may be connected to the contact hole of the first interlayer insulating layer ILD1 and the contact hole of the gate insulating layer GI.

The first connection electrode CNE1 may be arranged on the second interlayer insulating layer ILD2. In one or more embodiments, the first connection electrode CNE1 may electrically connect the drain electrode DE of the thin film transistor TFT to the second connection electrode CNE2. The first connection electrode CNE1 may be inserted into contact holes provided in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be arranged on the first passivation layer PAS1. The second connection electrode CNE2 may electrically connect the first connection electrode CNE1 to the pixel electrode such as AE1, AE2, or AE3 of the light emitting element ED. The second connection electrode CNE2 may be inserted into the contact hole formed in the first passivation layer PAS1 to be in contact with the first connection electrode CNE1.

The second passivation layer PAS2 may cover the second connection electrode CNE2 and the first passivation layer PAS1. The second passivation layer PAS2 may include a contact hole through which the pixel electrode such as AE1, AE2, or AE3 of the light emitting element ED passes.

The light emitting element layer EML may be arranged on the thin film transistor layer TFTL. The light emitting element layer EML may include the light emitting element ED and the pixel defining film PDL. The light emitting element ED may include a respective one selected from among the respective pixel electrodes AE1, AE2, and AE3, the light emitting layer EL, and a common electrode CE.

The pixel electrodes AE1, AE2, and AE3 may be arranged on the second passivation layer PAS2. The different pixel electrodes AE1, AE2, and AE3 may each be arranged to overlap any one of the different openings of the pixel defining film PDL. The pixel electrodes AE1, AE2, and AE3 may each be electrically connected to the drain electrode DE of one corresponding thin film transistor TFT through the first and second connection electrodes CNE1 and CNE2.

The light emitting layer EL may be respectively and independently arranged on the pixel electrodes AE1, AE2, and AE3. For example, the light emitting layer EL may be an organic light emitting layer made of an organic material, but embodiments of the present disclosure are not limited thereto. In the embodiments of employing the organic light emitting layer as the light emitting layer EL, the thin film transistor TFT applies a set or predetermined voltage to corresponding pixel electrode AE1, AE2, or AE3 of the light emitting element ED, and if (e.g., when) the common electrode CE of the light emitting element ED receives a common voltage or a cathode voltage, holes and electrons may move to the light emitting layer EL through the hole transporting layer and the electron transporting layer, respectively, and combine with each other in the light emitting layer EL to emit light.

In one or more embodiments, the light emitting layers EL respectively arranged on different pixel electrodes AE1, AE2, and AE3 may be to emit light of different colors. For example, in one or more embodiments, the light emitting layer arranged on the first pixel electrode AE1 may be to emit red light of the first color, the light emitting layer arranged on the second pixel electrode AE2 may be to emit green light of the second color, and the light emitting layer arranged on the third pixel electrode AE3 may be to emit blue light of the third color. However, embodiments of the present disclosure are not limited thereto. In one or more embodiments, the light emitting layer EL may be arranged as a single common layer on the different pixel electrodes AE1, AE2, and AE3 and the pixel defining film PDL, and the light emitting layer EL arranged on the different pixel electrodes AE1, AE2, and AE3 may be to emit light of the same color. In these embodiments, the display device 10 may further include a color adjustment layer arranged on the light emitting elements ED.

The common electrode CE may be arranged on the light emitting layer EL. For example, in one or more embodiments, the common electrode CE may be made in the form of an electrode common to all of the pixels rather than specific to each of the pixels. The common electrode CE may be arranged on the light emitting layer EL opposite to the pixel electrodes AE1, AE2, and AE3, and may be arranged on the pixel defining film PDL in the area except the pixel electrodes AE1, AE2, and AE3.

The common electrode CE may receive the common voltage or a low potential voltage. When the pixel electrodes AE1, AE2, and AE3 each receive a voltage corresponding to a data voltage and the common electrode CE receives the low potential voltage, a potential difference is formed between each of the pixel electrodes AE1, AE2, and AE3 and the common electrode CE, so that the light emitting layer EL may be to emit light.

The pixel defining film PDL may include a plurality of openings and may be arranged on a part of the pixel electrodes AE1, AE2, and AE3 and the second passivation layer PAS2. Each opening of the pixel defining film PDL may expose a part of corresponding one of the pixel electrodes AE1, AE2, and AE3. As described above, the respective openings of the pixel defining film PDL may define the first to third main emission areas MEA1, MEA2, and MEA3, and the areas or sizes thereof may be different from one another. The pixel defining film PDL may separate and insulate the pixel electrodes AE1, AE2, and AE3 of the plurality of light emitting elements ED.

The pixel defining film PDL may include a light absorbing material to prevent or reduce light reflection. For example, in one or more embodiments, the pixel defining film PDL may include a polyimide (PI)-based binder and a light absorbing material in which pigments absorbing light of red, green, and blue colors are mixed. In one or more embodiments, the pixel defining film PDL may include a cardo-based binder resin and a (e.g., any suitable) mixture of a lactam black pigment and a blue pigment. In one or more embodiments, the pixel defining film PDL may include carbon black.

The encapsulation layer TFEL may be arranged on the common electrode CE to cover the plurality of light emitting elements ED. The encapsulation layer TFEL may include at least one inorganic film to prevent or reduce oxygen and/or moisture from penetrating into the light emitting element layer EML. The encapsulation layer TFEL may include at least one organic film to protect the light emitting element layer EML from foreign matters such as dust.

In one or more embodiments, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2 arranged between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials. The inorganic insulating material may include aluminium oxide, titanium oxide, tantalum oxide, hafnium oxide, zinc oxide, silicon oxide, silicon nitride, and/or silicon oxynitride.

The second encapsulation layer TFE2 may include a polymer-based material. Non-limiting examples of the polymer-based material may include acrylic resins, epoxy resins, polyimide, polyethylene, and/or the like. For example, in one or more embodiments, the second encapsulation layer TFE2 may include an acrylic resin, for example, polymethyl methacrylate, polyacrylic acid, and/or the like. The second encapsulation layer TFE2 may be formed by curing a monomer or applying a polymer.

The touch sensing layer TSU may be arranged on the encapsulation layer TFEL. The touch sensing layer TSU may include a first touch insulating layer SIL1, a second touch insulating layer SIL2, a touch electrode TL, and a third touch insulating layer SIL3.

The first touch insulating layer SIL1 may be arranged on the encapsulation layer TFEL. The first touch insulating layer SIL1 may have an insulating and optical function. The first touch insulating layer SIL1 may include at least one inorganic film. In one or more embodiments, the first touch insulating layer SIL1 may not be provided.

The second touch insulating layer SIL2 may cover the first touch insulating layer SIL1. In one or more embodiments, a touch electrode of another layer may be further arranged on the first touch insulating layer SIL1, and the second touch insulating layer SIL2 may cover the touch electrode of another layer. The second touch insulating layer SIL2 may have an insulating and optical function. For example, in one or more embodiments, the second touch insulating layer SIL2 may be an inorganic film containing at least one of a silicon nitride layer, a silicon oxynitride layer, a silicon oxide layer, a titanium oxide layer, or an aluminium oxide layer.

A part of the touch electrode TL may be arranged on the second touch insulating layer SIL2. The touch electrode TL may not overlap the pixel electrodes AE1, AE2, and AE3. The touch electrode TL may be formed as a single layer containing molybdenum (Mo), titanium (Ti), copper (Cu), aluminium (Al), or indium tin oxide (ITO), or may be formed to have a stacked structure (Ti/Al/Ti) of aluminium and titanium, a stacked structure (ITO/AI/ITO) of aluminium and ITO, an Ag-Pd-Cu (APC) alloy, or a stacked structure (ITO/APC/ITO) of APC alloy and ITO.

The touch electrode TL of the touch sensing layer TSU may have a constant line width and may be arranged to overlap the light blocking layer BM. The light blocking layer BM may have a width enough to completely cover the touch electrode TL. In one or more embodiments, the touch electrode TL may be arranged such that the central portion thereof is substantially side by side with the central portion of the light blocking layer BM, and a distance from one side of the touch electrode TL to one side of the light blocking layer BM may be substantially equal to a distance from the other side of the touch electrode TL to the other side of the light blocking layer BM.

The third touch insulating layer SIL3 may cover the touch electrode TL and the second touch insulating layer SIL2. The third touch insulating layer SIL3 may have an insulating and optical function. The third touch insulating layer SIL3 may be made of the material exemplified in association with the second touch insulating layer SIL2.

The color filter layer CFL may include the light blocking layer BM, the first color filter layer CFL1, the second color filter layer CFL2, the third color filter layer CFL3, and an overcoat layer OC.

The light blocking layer BM may be arranged on the third touch insulating layer SIL3 of the touch sensing layer TSU. The light blocking layer BM may be arranged to overlap the conductive line of the touch electrode TL. The light blocking layer BM may be arranged to overlap the pixel defining film PDL in the third direction DR3.

The light blocking layer BM may include the plurality of main openings OPT_M arranged to overlap the main emission areas MEA. For example, the first main opening OPT1_M may overlap the first main emission area MEA1 in the third direction DR3, the second main opening OPT2_M may overlap the second main emission area MEA2 in the third direction DR3, and the third main opening OPT3_M may overlap the third main emission area MEA3 in the third direction DR3. Although not shown in FIG. 11, as shown in FIG. 6, the fourth main opening OPT4_M may overlap the fourth main emission area MEA4 in the third direction DR3.

The area or size of each of the main openings OPT_M may be larger than the area or size of the main emission area MEA. In addition, the area or size of each of the main openings OPT_M may be formed to be larger than that of the corresponding opening of the pixel defining film PDL, and light emitted from the light emitting element ED may be visually recognized by a user not only from the front of the display device 10 but also from the side thereof.

The light blocking layer BM may include a light absorbing material. For example, in one or more embodiments, the light blocking layer BM may include an inorganic black pigment and/or an organic black pigment. The inorganic black pigment may be carbon black, and the organic black pigment may include at least one of lactam black, perylene black, or aniline black, but they are not limited thereto.

The first color filter layer CFL1, the second color filter layer CFL2, and the third color filter layer CFL3 may be arranged on the light blocking layer BM. In one or more embodiments, the first color filter layer CFL1, the second color filter layer CFL2, and the third color filter layer CFL3 may be sequentially stacked on the light blocking layer BM, but embodiments of the present disclosure are not limited thereto.

The main color portion CF_M of the color filter layer CFL may include the first main color portion CF1_M of the first color filter layer CFL1, the second main color portion CF2_M of the second color filter layer CFL2, and the third main color portion CF3_M of the third color filter layer CFL3. Although not shown in FIG. 11, as shown in FIG. 9, the main color portion CF_M may further include the fourth main color portion CF4_M of the second color filter layer CFL2.

The main color portions CF_M may be arranged to correspond to the main emission areas MEA, respectively. For example, the first main color portion CF1_M may be arranged to overlap the first main emission area MEA1 in the third direction DR3, the second main color portion CF2_M may be arranged to overlap the second main emission area MEA2 in the third direction DR3, and the third main color portion CF3_M may be arranged to overlap the third main emission area MEA3 in the third direction DR3.

The main color portions CF_M may be arranged to correspond to the main openings OPT_M of the light blocking layer BM, respectively. For example, the first main color portion CF1_M may cover the first main opening OPT1_M, the second main color portion CF2_M may cover the second main opening OPT2_M, and the third main color portion CF3_M may cover the third main opening OPT3_M.

Widths of the main color portions CF_M may be greater than widths of the main openings OPT_M of the light blocking layer BM. For example, in one or more embodiments, a width of the first main color portion CF1_M may be greater than a width of the first main opening OPT1_M of the light blocking layer BM, a width of the second main color portion CF2_M may be greater than a width of the second main opening OPT2_M of the light blocking layer BM, and a width of the third main color portion CF3_M may be greater than a width of the third main opening OPT3_M of the light blocking layer BM.

The overcoat layer OC may be arranged on the light blocking layer BM, the first color filter layer CFL1, the second color filter layer CFL2, and the third color filter layer CFL3. The overcoat layer OC may be arranged over the entire display area DA to flatten the top surface of the display panel 100. The overcoat layer OC may be a colorless light transmissive layer that does not have a color in a visible light band. For example, in one or more embodiments, the overcoat layer OC may include a colorless light transmissive organic material such as an acrylic resin.

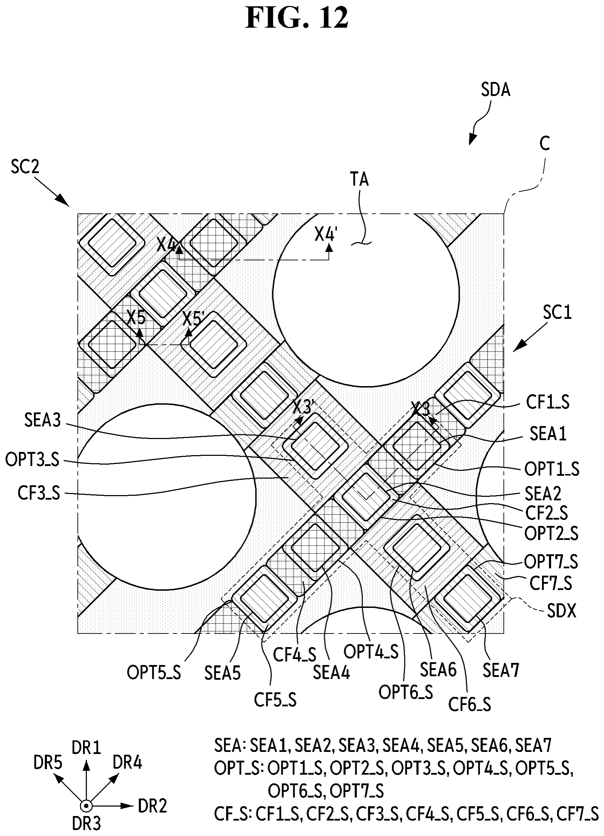

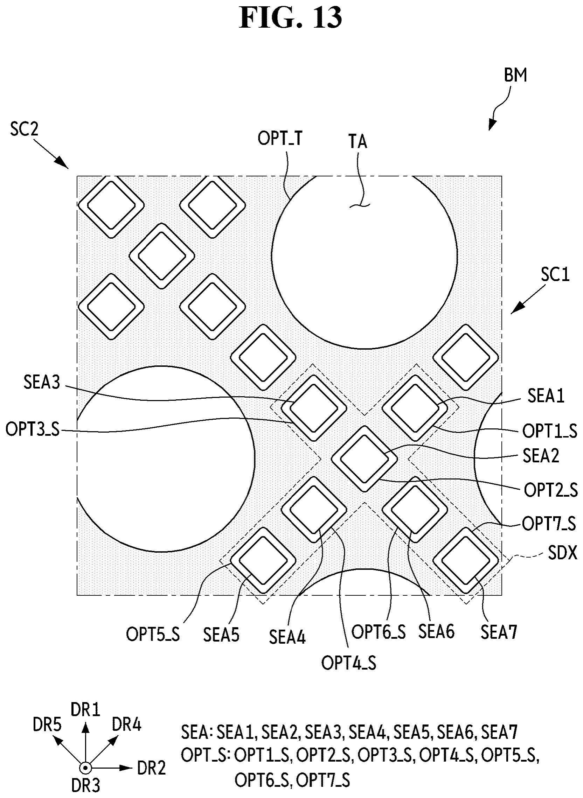

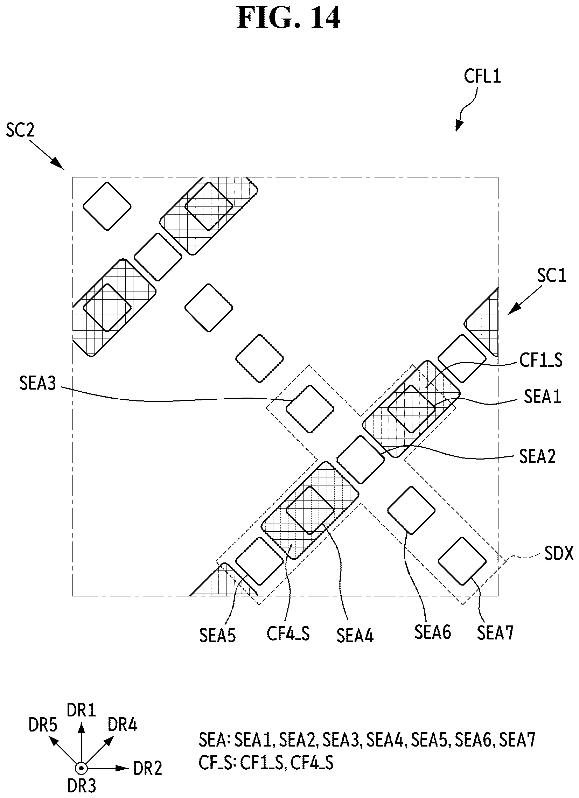

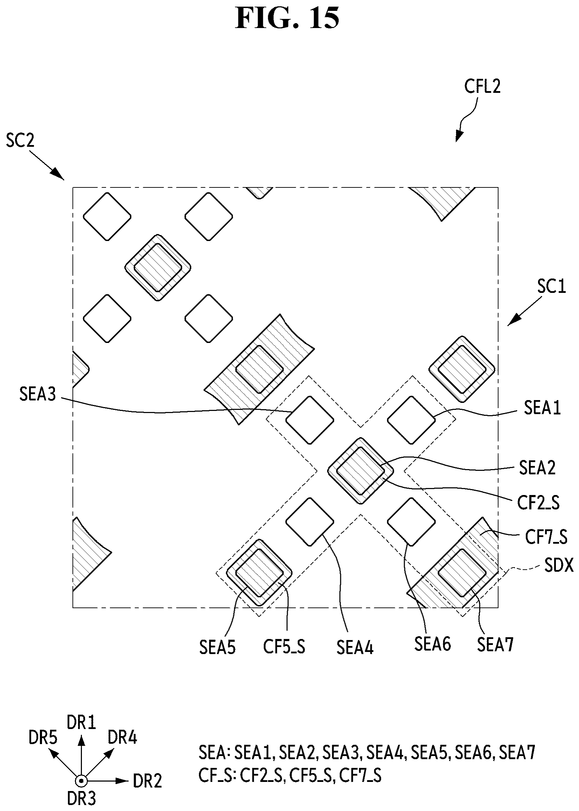

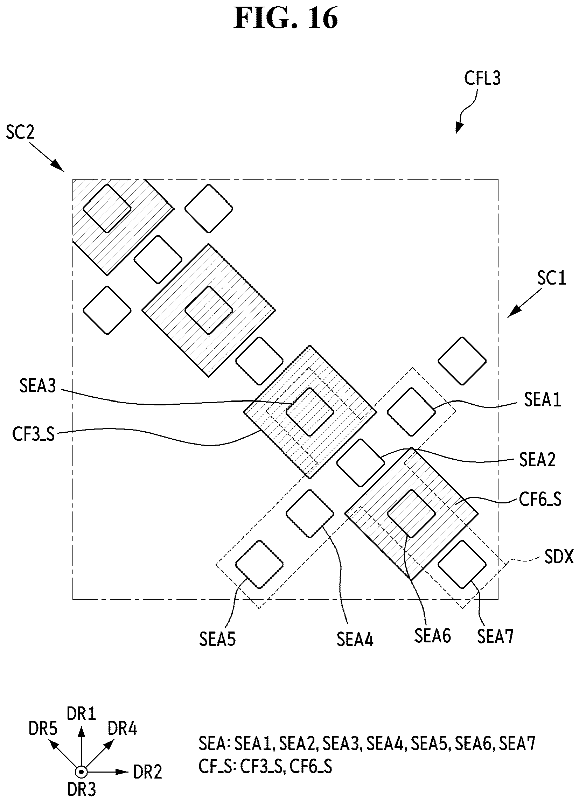

FIG. 12 is a layout diagram showing a light blocking layer, a first color filter layer, a second color filter layer, and a third color filter layer in area C of FIG. 4 according to one or more embodiments of the present disclosure. FIG. 13 is a layout diagram showing the light blocking layer in area C of FIG. 4 according to one or more embodiments of the present disclosure. FIG. 14 is a layout diagram showing the first color filter layer in area C of FIG. 4 according to one or more embodiments of the present disclosure. FIG. 15 is a layout diagram showing the second color filter layer in area C of FIG. 4 according to one or more embodiments of the present disclosure. FIG. 16 is a layout diagram showing the third color filter layer in area C of FIG. 4 according to one or more embodiments of the present disclosure.

Referring to FIGS. 12 to 16 in addition to FIGS. 5 to 11, the sub-display area SDA may include the plurality of sub-display pixels SDX. The plurality of sub-display pixels SDX may be arranged in the fourth direction DR4 and the fifth direction DR5. The sub-display pixels SDX may be repeatedly arranged in the arrangement of FIG. 12 throughout the sub-display area SDA.

Each of the plurality of sub-display pixels SDX may include a plurality of sub-emission areas SEA. For example, in one or more embodiments, each of the plurality of sub-display pixels SDX may include a first sub-emission area SEA1, a second sub-emission area SEA2, a third sub-emission area SEA3, a fourth sub-emission area SEA4, a fifth sub-emission area SEA5, a sixth sub-emission area SEA6, and a seventh sub-emission area SEA7. However, the number of sub-emission areas SEA included in the sub-display pixel SDX is not limited thereto, and may be variously changed.

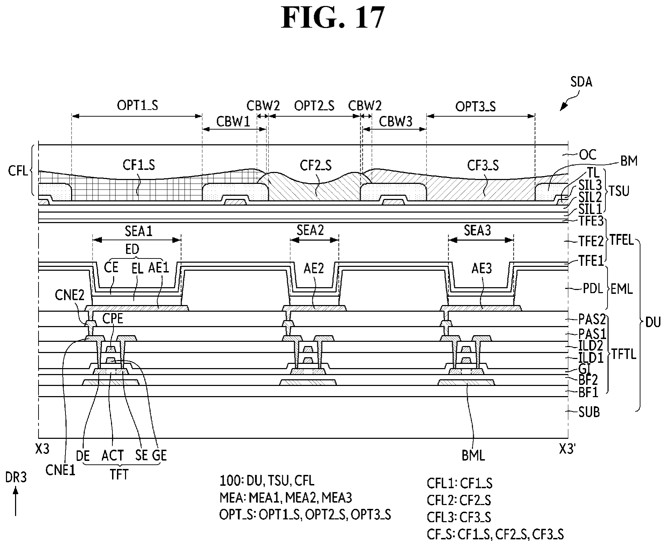

One sub-display pixel SDX may include one or more light emitting elements ED (see FIG. 17). One or more light emitting elements ED included in one sub-display pixel SDX (see FIG. 17) may be to emit light of the same color or different colors. For example, in one or more embodiments, the light emitting elements ED (see FIG. 17) arranged in the first sub-emission area SEA1 and the fourth sub-emission area SEA4 may be to emit first light of a red color, the light emitting elements ED (see FIG. 17) arranged in the second sub-emission area SEA2, the fifth sub-emission area SEA5, and the seventh sub-emission area SEA7 may be to emit second light of a green color, and the light emitting elements ED (see FIG. 17) arranged in the third sub-emission area SEA3 and the sixth sub-emission area SEA6 may be to emit third light of a blue color.

The sub-emission area SEA may be an area where the light emitting layer EL (see FIG. 17) overlaps the corresponding pixel electrode AE1, AE2, or AE3 (see FIG. 17). For example, an opening of the pixel defining film PDL (see FIG. 17) may correspond to the sub-emission area SEA. For example, the sub-emission areas SEA may be respectively defined by a plurality of openings of the pixel defining film PDL (see FIG. 17) of the light emitting element layer EML (see FIG. 17).

The first sub-emission area SEA1 may be defined by a first opening of the pixel defining film PDL (see FIG. 17) that overlaps the first pixel electrode AE1 (see FIG. 17), the second sub-emission area SEA2 may be defined by a second opening of the pixel defining film PDL (see FIG. 17) that overlaps the second pixel electrode AE2 (see FIG. 17), and the third sub-emission area SEA3 may be defined by a third opening of the pixel defining film PDL (see FIG. 17) that overlaps the third pixel electrode AE3 (see FIG. 17). Although not shown in FIG. 17, as shown in FIG. 12, the fourth sub-emission area SEA4 may be defined by a fourth opening of the pixel defining film PDL (see FIG. 17) that overlaps the fourth pixel electrode, the fifth sub-emission area SEAS may be defined by a fifth opening of the pixel defining film PDL (see FIG. 17) that overlaps a fifth pixel electrode, the sixth sub-emission area SEA6 may be defined by a sixth opening of the pixel defining film PDL (see FIG. 17) that overlaps a sixth pixel electrode, and the seventh sub-emission area SEA7 may be defined by a seventh opening of the pixel defining film PDL (see FIG. 17) that overlaps a seventh pixel electrode.

The plurality of sub-emission areas SEA may be arranged in a first sub-diagonal column SC1 and a second sub-diagonal column SC2. The first sub-diagonal column SC1 may be an area extending in the fourth direction DR4 in the sub-display area SDA without overlapping the transmission area TA, and the second sub-diagonal column SC2 may be an area extending in the fifth direction DR5 in the sub-display area SDA without overlapping the transmission area TA.

In the first sub-diagonal column SC1, the first sub-emission area SEA1, the second sub-emission area SEA2, the fourth sub-emission area SEA4, and the fifth sub-emission area SEAS of the sub-display pixel SDX may be sequentially arranged in the fourth direction DR4. In the second sub-diagonal column SC2, the third sub-emission area SEA3, the second sub-emission area SEA2, the sixth sub-emission area SEA6, and the seventh sub-emission area SEA7 of the sub-display pixel SDX may be sequentially arranged in the fifth direction DR5.

In one or more embodiments, the areas or sizes of the first to seventh sub-emission areas SEA1, SEA2, SEA3, SEA4, SEAS, SEA6, and SEA7 may be different from one another. In one or more embodiments of FIG. 12, the area of each the first sub-emission area SEA1 and the fourth sub-emission area SEA4 may be larger than the area of each of the second sub-emission area SEA2, the third sub-emission area SEA3, the fifth sub-emission area SEA5, the sixth sub-emission area SEA6, and the seventh sub-emission area SEA7, and the area of each of the third sub-emission area SEA3 and the sixth sub-emission area SEA6 may be larger than the area of each of the second sub-emission area SEA2, the fifth sub-emission area SEA5, and the seventh sub-emission area SEA7. The intensity of emitted light may vary depending on the area of each sub-emission area SEA, and the color of the screen displayed on the display device 10 may be controlled or selected by adjusting the area of each sub-emission area SEA. In one or more embodiments of FIG. 12, the first sub-emission area SEA1 and the fourth sub-emission area SEA4 having the largest area are illustrated, but embodiments of the present disclosure are not limited thereto. Depending on the color of the screen desired or required for the display device 10, the size of each sub-emission area SEA and the area of the emission area may be freely and suitably adjusted. In addition, the area of each sub-emission area SEA may be related to light efficiency, the lifespan of the light emitting element ED (see FIG. 17), and/or the like, and may have a trade-off relationship with the reflection by external light. The area of each sub-emission area SEA may be adjusted in consideration of the above factors.

Although it is illustrated in the drawing that each of the sub-emission areas SEA of one or more embodiments has a quadrilateral shape with rounded corners in plan view, embodiments of the present disclosure are not limited thereto.

The sub-display area SDA may further include the transmission area TA. The transmission area TA has been described above and thus will not be repeated for conciseness.

The display device 10 may include the light blocking layer BM, and the first color filter layer CFL1, the second color filter layer CFL2, and the third color filter layer CFL3 that are arranged on the light blocking layer BM.

The light blocking layer BM may be arranged over the entire display area DA. For example, the light blocking layer BM may be arranged in the main display area MDA and the sub-display area SDA.

The light blocking layer BM may include a plurality of sub-openings OPT_S arranged in the sub-display area SDA and arranged to respectively correspond to the sub-emission area SEA. The light blocking layer BM may cover the sub-display area SDA except the area where the plurality of sub-openings OPT_S are arranged in the sub-display area SDA. The plurality of sub-openings OPT_S of the light blocking layer BM may be areas where light emitted from the light emitting elements ED (see FIG. 17) corresponding to the sub-emission areas SEA is emitted.

The plurality of sub-openings OPT_S may include a first sub-opening OPT1_S overlapping the first sub-emission areas SEA1, a second sub-opening OPT2_S overlapping the second sub-emission areas SEA2, a third sub-opening OPT3_S overlapping the third sub-emission areas SEA3, a fourth sub-opening OPT4_S overlapping the fourth sub-emission areas SEA4, a fifth sub-opening OPT5_S overlapping the fifth sub-emission areas SEAS, a sixth sub-opening OPT6_S overlapping the sixth sub-emission areas SEA6, and a seventh sub-opening OPT7_S overlapping the seventh sub-emission areas SEA7.

A planar area of each of the plurality of sub-openings OPT_S may be larger than a planar area of each corresponding sub-emission area SEA. For example, the planar area of the first sub-opening OPT1_S may be larger than that of the first sub-emission area SEA1, the planar area of the second sub-opening OPT2_S may be larger than that of the second sub-emission area SEA2, the planar area of the third sub-opening OPT3_S may be larger than that of the third sub-emission area SEA3, the planar area of the fourth sub-opening OPT4_S may be larger than that of the fourth sub-emission area SEA4, the planar area of the fifth sub-opening OPT5_S may be larger than that of the fifth sub-emission area SEAS, the planar area of the sixth sub-opening OPT6_S may be larger than that of the sixth sub-emission area SEA6, and the planar area of the seventh sub-opening OPT7_S may be larger than that of the seventh sub-emission area SEA7.

The light blocking layer BM may include transmission window openings OPT_T arranged in the sub-display area SDA and arranged between the plurality of sub-openings OPT_S. The transmission window opening OPT_T may be arranged in the transmission area TA. The plurality of transmission window openings OPT_T may be arranged in the first direction DR1 and the second direction DR2. The plurality of sub-openings OPT_S may be arranged not only between the first direction DR1 and the second direction DR2 of the plurality of transmission window openings OPT_T but also between the fourth direction DR4 and the fifth direction DR5 thereof.

The first color filter layer CFL1 may be arranged on the light blocking layer BM. The second color filter layer CFL2 may be arranged on the first color filter layer CFL1. The third color filter layer CFL3 may be arranged on the second color filter layer CFL2.

The first color filter layer CFL1 may include a first sub-color portion CF1_S and a fourth sub-color portion CF4_S arranged in the sub-display area SDA, the second color filter layer CFL2 may include a second sub-color portion CF2_S, a fifth sub-color portion CF5_S, and a seventh sub-color portion CF7_S arranged in the sub-display area SDA, and the third color filter layer CFL3 may include a third sub-color portion CF3_S and a sixth sub-color portion CF6_S arranged in the sub-display area SDA. The first to seventh sub-color portions CF1_S, CF2_S, CF3_S, CF4_S, CF5_S, CF6_S, and CF7_S may be included in the sub-color portion CF_S.

The sub-color portion CF_S may contain a colorant, such as a dye and/or a pigment, that absorbs light in a wavelength band other than a specific wavelength band, and may be arranged to correspond to the color of the light emitted by the light emitting element ED (see FIG. 17). For example, in one or more embodiments, the first sub-color portion CF1_S and the fourth sub-color portion CF4_S may be red color filters transmitting only the first light of the red color and arranged to overlap the first sub-emission area SEA1 and the fourth sub-emission area SEA4, respectively. The second sub-color portion CF2_S, the fifth sub-color portion CF5_S, and the seventh sub-color portion CF7_S may be green color filters transmitting only the second light of the green color and arranged to overlap the second sub-emission area SEA2, the fifth sub-emission area SEA5, and the seventh sub-emission area SEA7, respectively. The third sub-color portion CF3_S and the sixth sub-color portion CF6_S may be blue color filters transmitting only the third light of the blue color and arranged to overlap the third sub-emission area SEA3 and the sixth sub-emission area SEA6, respectively.

The plurality of sub-color portions CF_S may be arranged to correspond to the plurality of sub-emission areas SEA, respectively. For example, in one or more embodiments, the first sub-color portion CF1_S may be arranged to overlap the first sub-emission area SEA1, and the second sub-color portion CF2_S may be arranged to overlap the second sub-emission area SEA2. The third sub-color portion CF3_S may be arranged to overlap the third sub-emission area SEA3, and the fourth sub-color portion CF4_S may be arranged to overlap the fourth sub-emission area SEA4. The fifth sub-color portion CF5_S may be arranged to overlap the fifth sub-emission area SEA5, the sixth sub-color portion CF6_S may be arranged to overlap the sixth sub-emission area SEA6, and the seventh sub-color portion CF7_S may be arranged to overlap the seventh sub-emission area SEA7.

In the first sub-diagonal column SC1, the first sub-color portion CF1_S, the second sub-color portion CF2_S, the fourth sub-color portion CF4_S, and the fifth sub-color portion CF5_S may be sequentially arranged in the fourth direction DR4. In the second sub-diagonal column SC2, the third sub-color portion CF3_S, the second sub-color portion CF2_S, the sixth sub-color portion CF6_S, and the seventh sub-color portion CF7_S may be sequentially arranged in the fifth direction DR5.

In the first sub-diagonal column SC1, the first sub-color portion CF1_S and the fourth sub-color portion CF4_S may be alternately arranged to be spaced and/or apart (e.g., spaced apart or separated) from each other in the fourth direction DR4. In the first sub-diagonal column SC1, the second sub-color portion CF2_S and the fifth sub-color portion CF5_S may be alternately arranged to be spaced and/or apart (e.g., spaced apart or separated) from each other in the fourth direction DR4. In the second sub-diagonal column SC2, the second sub-color portion CF2_S and the seventh sub-color portion CF7_S may be alternately arranged to be spaced and/or apart (e.g., spaced apart or separated) from each other in the fifth direction DR5. In the second sub-diagonal column SC2, the third sub-color portion CF3_S and the sixth sub-color portion CF6_S may be alternately arranged to be spaced and/or apart (e.g., spaced apart or separated) from each other in the fifth direction DR5.

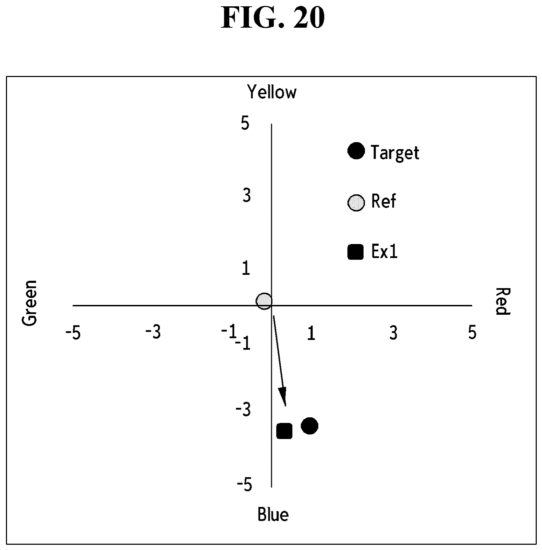

The planar sizes or areas of the plurality of sub-color portions CF_S may be different from one another. As described above, the sizes of areas of the plurality of sub-emission areas SEA may be different from one another, so that the planar sizes or areas of the plurality of sub-color portions CF_S may also be different from one another. For example, in one or more embodiments, the size or area of each of the third sub-color portion CF3_S and the sixth sub-color portion CF6_S may be larger than the size or area of each of the first sub-color portion CF1_S, the second sub-color portion CF2_S, the fourth sub-color portion CF4_S, the fifth sub-color portion CF5_S, and the seventh sub-color portion CF7_S. Further, the size or area of each of the first sub-color portion CF1_S and the fourth sub-color portion CF4_S may be larger than the size or area of each of the second sub-color portion CF2_S, the fifth sub-color portion CF5_S, and the seventh sub-color portion CF7_S. The size of each of the plurality of sub-color portions CF_S is closely related to the color of the sub-display area SDA according to the reflection of external light, and this will be described in more detail later with reference to FIG. 20.

The planar area of each of the plurality of sub-color portions CF_S may be larger than the planar area of each corresponding sub-emission area SEA. For example, the planar area of the first sub-color portion CF1_S may be larger than that of the first sub-emission area SEA1, the planar area of the second sub-color portion CF2_S may be larger than that of the second sub-emission area SEA2, the planar area of the third sub-color portion CF3_S may be larger than that of the third sub-emission area SEA3, the planar area of the fourth sub-color portion CF4_S may be larger than that of the fourth sub-emission area SEA4, the planar area of the fifth sub-color portion CF5_S may be larger than that of the fifth sub-emission area SEAS, the planar area of the sixth sub-color portion CF6_S may be larger than that of the sixth sub-emission area SEA6, and the planar area of the seventh sub-color portion CF7_S may be larger than that of the seventh sub-emission area SEA7.

The plurality of sub-color portions CF_S may be arranged to correspond to the plurality of sub-openings OPT_S of the light blocking layer BM, respectively. For example, the first sub-color portion CF1_S may be arranged to overlap the first sub-opening OPT1_S of the light blocking layer BM, the second sub-color portion CF2_S may be arranged to overlap the second sub-opening OPT2_S of the light blocking layer BM, the third sub-color portion CF3_S may be arranged to overlap the third sub-opening OPT3_S of the light blocking layer BM, the fourth sub-color portion CF4_S may be arranged to overlap the fourth sub-opening OPT4_S of the light blocking layer BM, the fifth sub-color portion CF5_S may be arranged to overlap the fifth sub-opening OPT5_S of the light blocking layer BM, the sixth sub-color portion CF6_S may be arranged to overlap the sixth sub-opening OPT6_S of the light blocking layer BM, and the seventh sub-color portion CF7_S may be arranged to overlap the seventh sub-opening OPT7_S of the light blocking layer BM.

The planar area of each of the plurality of sub-color portions CF_S may be larger than the planar area of each corresponding sub-opening OPT_S of the light blocking layer BM. For example, the planar area of the first sub-color portion CF1_S may be larger than that of the first sub-opening OPT1_S of the light blocking layer BM, the planar area of the second sub-color portion CF2_S may be larger than that of the second sub-opening OPT2_S of the light blocking layer BM, the planar area of the third sub-color portion CF3_S may be larger than that of the third sub-opening OPT3_S of the light blocking layer BM, the planar area of the fourth sub-color portion CF4_S may be larger than that of the fourth sub-opening OPT4_S of the light blocking layer BM, the planar area of the fifth sub-color portion CF5_S may be larger than that of the fifth sub-opening OPT5_S of the light blocking layer BM, the planar area of the sixth sub-color portion CF6_S may be larger than that of the sixth sub-opening OPT6_S of the light blocking layer BM, and the planar area of the seventh sub-color portion CF7_S may be larger than that of the seventh sub-opening OPT7_S of the light blocking layer BM. Accordingly, the plurality of sub-color portions CF_S may respectively completely cover the sub-openings OPT_S of the light blocking layer BM.

Although it is illustrated in the drawing that each of the sub-color portions CF_S of one or embodiments has a substantially quadrilateral planar shape, embodiments of the present disclosure are not limited thereto.

In the display device 10 according to the present embodiment, an area ratio of colors in the main emission area MEA of the main display pixel MDX may be different from an area ratio of colors in the sub-emission area SEA of the sub-display pixel SDX. For example, a ratio of the area of the first main emission area MEA1 that emits red light, to the sum of the areas of the second main emission area MEA2 and the fourth main emission area MEA4 that emit green light, and to the area of the third main emission area MEA3 that emits blue light in the main display pixel MDX may be different from a ratio of the sum of the areas of the first sub-emission area SEA1 and the fourth sub-emission area SEA4 that emit red light, to the sum of the areas of the second sub-emission area SEA2, the fifth sub-emission area SEA5, and the seventh sub-emission area SEA7 that emit green light, and to the sum of the areas of the third sub-emission area SEA3 and the sixth sub-emission area SEA6 that emit blue light in the sub-display pixel SDX.

In one or more embodiments, in the main display pixel MDX, the area of the first main emission area MEA1 that emits red light may be 25% or more of the total area (i.e., the sum of the areas of the first to fourth main emission areas MEA1, MEA2, MEA3, and MEA4), the sum of the areas of the second main emission area MEA2 and the fourth main emission area MEA4 that emit green light may be 50% or more of the total area, and the area of the third main emission area MEA3 that emits blue light may be 20% or less of the total area.

In one or more embodiments, in the sub-display pixel SDX, the sum of the areas of the first sub-emission area SEA1 and the fourth sub-emission area SEA4 that emit red light may be 25% or more of the total area (i.e., the sum of the areas of the first to seventh sub-emission areas SEA1, SEA2, SEA3, SEA4, SEA5, SEA6, and SEA7), the sum of the areas of the second sub-emission area SEA2, the fifth sub-emission area SEA5, and the seventh sub-emission area SEA7 that emit green light may be 50% or less of the total area, and the sum of the areas of the third sub-emission area SEA3 and the sixth sub-emission area SEA6 that emit blue light may be 20% or more of the total area.

In the display device 10 according to the present embodiment, the ratio of the area of the sub-emission areas SEA that emits green light to the area of the entire sub-emission area SEA in the sub-display pixel SDX may be less than the ratio of the area of the main emission areas MEA that emits green light to the area of the entire main emission area MEA in the main display pixel MDX. Accordingly, a color difference may occur between the main emission area MEA and the sub-emission area SEA.

Further, in one or more embodiments, the fifth sub-color portion CF5_S may be arranged between the transmission areas TA in the fifth direction DR5, and the seventh sub-color portion CF7_S may be arranged between the transmission areas TA in the fourth direction DR4. For example, by arranging the sub-emission area SEA and the sub-color portion CF_S in the bridge area BRA in order to increase the resolution of the sub-display area SDA, a color difference may occur between the main emission area MEA and the sub-emission area SEA.

In the display device 10 according to the present embodiment, in order to minimize or reduce the color difference between the main emission area MEA and the sub-emission area SEA, the size or area of the seventh sub-color portion CF7_S, which is a green color filter, may be expanded. For example, a length of the seventh sub-color portion CF7_S in the fourth direction DR4 may be greater than that in the fifth direction DR5. The length of both ends of the seventh sub-color portion CF7_S in the fourth direction DR4 may be extended such that they are arranged adjacent to the transmission area TA.

In one or more embodiments, although not shown in the drawing, the size or area of the fifth sub-color portion CF5_S, which is a green color filter, may be expanded. For example, a length of the fifth sub-color portion CF5_S in the fifth direction DR5 may be greater than that in the fourth direction DR4. The length of both ends of the fifth sub-color portion CF5_S in the fifth direction DR5 may be extended such that they are arranged adjacent to the transmission area TA.

Even if the area of the sub-emission area SEA that emits green light becomes smaller than the area of the main emission area MEA that emits green light, the color reflected by the green color filter increases due to the expansion of the size or area of the seventh sub-color portion CF7_S or the fifth sub-color portion CF5_S, thereby minimizing or reducing the color difference between the main display pixel MDX and the sub-display pixel SDX.

The size or area of the seventh sub-color portion CF7_S may be larger than the size or area of the second sub-color portion CF2_S. In one or more embodiments, although not shown in the drawing, the size or area of the fifth sub-color portion CF5_S may be larger than the size or area of the second sub-color portion CF2_S. The second sub-color portion CF2_S is positioned in the central area CTA and is directly adjacent to a red emission area and a blue emission area in the fourth direction DR4 and the fifth direction DR5, so that red and blue colors may be affected if (e.g., when) the size or area of the second sub-color portion CF2_S is expanded. In contrast, the fifth sub-color portion CF5_S is arranged adjacent to the transmission areas TA in the fifth direction DR5, and the seventh sub-color portion CF7_S is arranged adjacent to the transmission areas TA in the fourth direction DR4, so that the effect on the red and blue colors may be minimized or reduced by expanding the size or area of the fifth sub-color portion CF5_S and/or the seventh sub-color portion CF7_S.

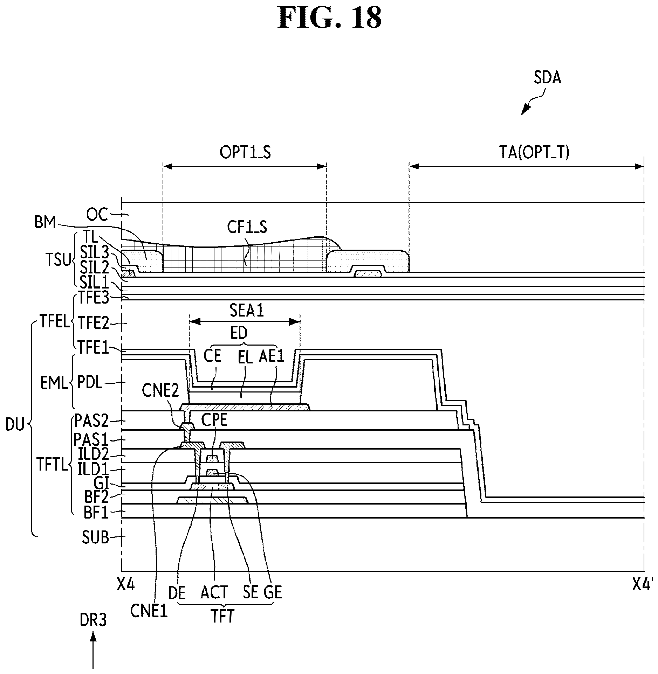

Meanwhile, the transmission area TA is arranged in the sub-display area SDA, and a lower layer (e.g., the first passivation layer PAS1 (see FIG. 18)) may be exposed in the transmission area TA. In this case, a unique color (e.g., relatively yellow) of the lower layer such as the first passivation layer PAS1 (see FIG. 18) may be exposed through the transmission area TA, so that the color difference may occur between the sub-display area SDA and the main display area MDA.

In the display device 10 according to the present embodiment, in order to minimize or reduce the color difference between the main display area MDA and the sub-display area SDA, the sizes or areas of the third sub-color portion CF3_S and the sixth sub-color portion CF6_S, which are blue color filters, may be expanded. Further, the sizes or areas of the first sub-color portion CF1_S and the fourth sub-color portion CF4_S, which are red color filters, may be expanded.

For example, in one or more embodiments, an area of the third sub-color portion CF3_S except the area of the third sub-emission area SEA3 and an area of the sixth sub-color portion CF6_S except the area of the sixth sub-emission area SEA6 may be larger than an area of the second sub-color portion CF2_S except the area of the second sub-emission area SEA2, an area of the fifth sub-color portion CF5_S except the area of the fifth sub-emission area SEA5, and an area of the seventh sub-color portion CF7_S except the area of the seventh sub-emission area SEA7. Similarly, an area of the first sub-color portion CF1_S except the area of the first sub-emission area SEA1 and an area of the fourth sub-color portion CF4_S except the area of the fourth sub-emission area SEA4 may be larger than the area of the second sub-color portion CF2_S except the area of the second sub-emission area SEA2, the area of the fifth sub-color portion CF5_S except the area of the fifth sub-emission area SEA5, and the area of the seventh sub-color portion CF7_S except the area of the seventh sub-emission area SEA7.

For example, in one or more embodiments, the area where the second sub-color portion CF2_S, the fifth sub-color portion CF5_S, and the seventh sub-color portion CF7_S cover a top surface of the light blocking layer BM may be smaller than the area where the first sub-color portion CF1_S and the fourth sub-color portion CF4_S cover the top surface of the light blocking layer BM and the area where the third sub-color portion CF3_S and the sixth sub-color portion CF6_S cover the top surface of the light blocking layer BM.

In one or more embodiments, the length of each of the third sub-color portion CF3_S and the sixth sub-color portion CF6_S in the fourth direction DR4 may be greater than the length of each of the second sub-color portion CF2_S, the fifth sub-color portion CF5_S, and the seventh sub-color portion CF7_S in the fourth direction DR4. The length of each of the third sub-color portion CF3_S and the sixth sub-color portion CF6_S in the fifth direction DR5 may be greater than the length of each of the second sub-color portion CF2_S, the fifth sub-color portion CF5_S, and the seventh sub-color portion CF7_S in the fifth direction DR5.

Similarly, the length of each of the first sub-color portion CF1_S and the fourth sub-color portion CF4_S in the fourth direction DR4 may be greater than the length of each of the second sub-color portion CF2_S and the fifth sub-color portion CF5_S in the fourth direction DR4. Although not shown in the drawing, in one or more embodiments, the length of each of the first sub-color portion CF1_S and the fourth sub-color portion CF4_S in the fifth direction DR5 may be extended such that the length of each of the first sub-color portion CF1_S and the fourth sub-color portion CF4_S in the fifth direction DR5 becomes greater than the length of each of the second sub-color portion CF2_S, the fifth sub-color portion CF5_S, and the seventh sub-color portion CF7_S in the fifth direction DR5.

In one or more embodiments, the sum of the areas of the first sub-color portion CF1_S and the fourth sub-color portion CF4_S, which are red color filters, may be 25% or more of the total area (i.e., the sum of the areas of the first to seventh sub-color portions CF1_S, CF2_S, CF3_S, CF4_S, CF5_S, CF6_S, and CF7_S), the sum of the areas of the second sub-color portion CF2_S, the fifth sub-color portion CF5_S, and the seventh sub-color portion CF7_S, which are green color filters, may be 40% or less of the total area, and the sum of the areas of the third sub-color portion CF3_S and the sixth sub-color portion CF6_S, which are blue color filters, may be 40% or more of the total area.

In this way, by expanding the size or area of the sub-color portion CF_S that reflects a specific color, the color difference between the sub-display area SDA and the main display area MDA, which may occur due to the exposure of the lower layer by the arrangement of the transmission area TA, may be minimized or reduced.

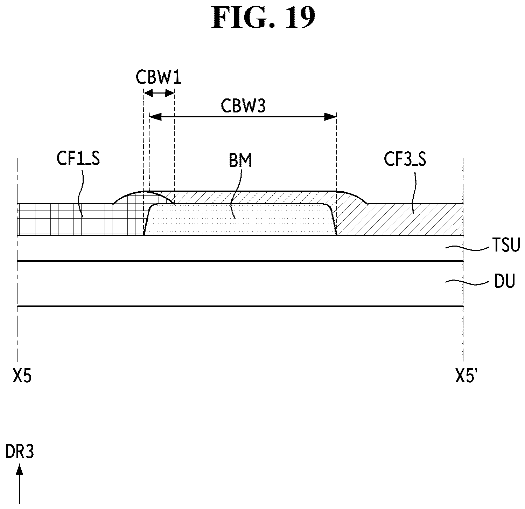

FIG. 17 is a cross-sectional view taken along the line X3-X3' of FIG. 12 according to one or more embodiments of the present disclosure. FIG. 18 is a cross-sectional view taken along the line X4-X4' of FIG. 12 according to one or more embodiments of the present disclosure. FIG. 19 is a cross-sectional view taken along the line X5-X5' of FIG. 12 according to one or more embodiments of the present disclosure.

Referring to FIGS. 17 to 19 in addition to FIGS. 5 to 16, the display layer DU and the touch sensing layer TSU have been described above and thus will not be repeated for conciseness.

The color filter layer CFL may include the light blocking layer BM, the first color filter layer CFL1, the second color filter layer CFL2, the third color filter layer CFL3, and the overcoat layer OC.

The light blocking layer BM may include the plurality of sub-openings OPT_S that are arranged to overlap the sub-emission areas SEA. For example, the first sub-opening OPT1_S may overlap the first sub-emission area SEA1 in the third direction DR3, the second sub-opening OPT2_S may overlap the second sub-emission area SEA2 in the third direction DR3, and the third sub-opening OPT3_S may overlap the third sub-emission area SEA3 in the third direction DR3. Although not shown in FIG. 17, as shown in FIG. 12, the fourth sub-opening OPT4_S may overlap the fourth sub-emission area SEA4 in the third direction DR3, the fifth sub-opening OPT5_S may overlap the fifth sub-emission area SEA5 in the third direction DR3, the sixth sub-opening OPT6_S may overlap the sixth sub-emission area SEA6 in the third direction DR3, and the seventh sub-opening OPT7_S may overlap the seventh sub-emission area SEA7 in the third direction DR3.

The area or size of each of the sub-openings OPT_S may be larger than the area or size of the sub-emission area SEA. Further, the areas or sizes of the respective sub-openings OPT_S may be formed to be larger than those of the openings of the pixel defining film PDL, and the light emitted from the light emitting element ED may be visually recognized by the user not only from the front of the display device 10 but also from the side thereof.

The sub-color portion CF_S of the color filter layer CFL may include the first sub-color portion CF1_S of the first color filter layer CFL1, the second sub-color portion CF2_S of the second color filter layer CFL2, and the third sub-color portion CF3_S of the third color filter layer CFL3. Although not shown in FIG. 17, as shown in FIG. 12, the sub-color portion CF_S may further include the fourth sub-color portion CF4_S of the first color filter layer CFL1, the fifth sub-color portion CF5_S and the seventh sub-color portion CF7_S of the second color filter layer CFL2, and the sixth sub-color portion CF6_S of the third color filter layer CFL3.

The sub-color portions CF_S may be arranged to respectively correspond to the sub-emission areas SEA. For example, the first sub-color portion CF1_S may be arranged to overlap the first sub-emission area SEA1 in the third direction DR3, the second sub-color portion CF2_S may be arranged to overlap the second sub-emission area SEA2 in the third direction DR3, and the third sub-color portion CF3_S may be arranged to overlap the third sub-emission area SEA3 in the third direction DR3.

The sub-color portions CF_S may be arranged to respectively correspond to the sub-openings OPT_S of the light blocking layer BM. For example, the first sub-color portion CF1_S may cover the first sub-opening OPT1_S, the second sub-color portion CF2_S may cover the second sub-opening OPT2_S, and the third sub-color portion CF3_S may cover the third sub-opening OPT3_S.

Widths of the sub-color portions CF_S may be greater than widths of the sub-openings OPT_S of the light blocking layer BM. For example, in one or more embodiments, a width of the first sub-color portion CF1_S may be greater than a width of the first sub-opening OPT1_S of the light blocking layer BM, a width of the second sub-color portion CF2_S may be greater than a width of the second sub-opening OPT2_S of the light blocking layer BM, and a width of the third sub-color portion CF3_S may be greater than a width of the third sub-opening OPT3_S of the light blocking layer BM.

In the display device 10 according to the present embodiment, as illustrated in FIG. 18, the transmission window opening OPT_T of the light blocking layer BM is arranged in the transmission area TA of the sub-display area SDA, so that lower layers positioned in the display layer DU may be visually recognized from the outside. For example, the first passivation layer PAS1 and the first encapsulation layer TFE1 may extend to the transmission area TA and, in this case, the first passivation layer PAS1 and the first encapsulation layer TFE1 may be visually recognized from the outside through the transmission window opening OPT_T. In one or more embodiments, the first passivation layer PAS1 is relatively yellow, so that the color of the sub-display area SDA may be different from the color of the main display area MDA.

Accordingly, in the display device 10 according to the present embodiment, in order to minimize or reduce the color difference between the main display area MDA and the sub-display area SDA, the sizes or areas of the third sub-color portion CF3_S and the sixth sub-color portion CF6_S, which are blue color filters, may be expanded. Further, the sizes or areas of the first sub-color portion CF1_S and the fourth sub-color portion CF4_S, which are red color filters, may be expanded.

In one or more embodiments, a width of a second overlapping area CBW2 where the second sub-color portion CF2_S overlaps the light blocking layer BM may be less than a width of a first overlapping area CBW1 where the first sub-color portion CF1_S overlaps the light blocking layer BM and a width of a third overlapping area CBW3 where the third sub-color portion CF3_S overlaps the light blocking layer BM. For example, by increasing the area where the first sub-color portion CF1_S and the third sub-color portion CF3_S cover the sub-display area SDA, the color difference between the sub-display area SDA and the main display area MDA, which may occur due to the exposure of the lower layer by the arrangement of the transmission window opening OPT_T, may be minimized or reduced.

In one or more embodiments, as illustrated in FIG. 19, the width of the first overlapping area CBW1 where the first sub-color portion CF1_S overlaps the light blocking layer BM may be less than the width of the third overlapping area CBW3 where the third sub-color portion CF3_S overlaps the light blocking layer BM. In one or more embodiments, the width of the third overlapping area CBW3 where the third sub-color portion CF3_S overlaps the light blocking layer BM may be less than the width of the first overlapping area CBW1 where the first sub-color portion CF1_S overlaps the light blocking layer BM. In this way, by controlling the size of the area where the sub-color portion CF_S and the light blocking layer BM overlap for each color, the overall reflection color of the sub-display area SDA may be controlled or selected and, accordingly, the color difference between the main display area MDA and the sub-display area SDA may be minimized or reduced.

FIG. 20 is a graph showing a'-b' color difference plots of display devices according to a comparative example and one embodiment of the present disclosure, which were measured by a Specular Component Excluded (SCE) measurement method.

Referring to FIG. 20 in addition to FIGS. 5 to 19, the sizes or areas of the sub-color portions CF_S of the display device 10 according to the comparative example may be substantially the same. For example, the sizes or areas of the first sub-color portion CF1_S and the fourth sub-color portion CF4_S, which are red color filters, the second sub-color portion CF2_S, the fifth sub-color portion CF5_S, and the seventh sub-color portion CF7_S, which are green color filters, and the third sub-color portion CF3_S and the sixth sub-color portion CF6_S, which are blue color filters, are the same. In contrast, in the display device 10 according to one embodiment of the present disclosure, as described with reference to FIG. 12 and/or the like, the sizes or areas of the sub-color portions CF_S are different for each color.

In the graph illustrated in FIG. 20, the horizontal axis representing the a'-axis of a CIELAB color space indicates a color change from red to green, and the vertical axis representing the b'-axis of the CIELAB color space indicates a color change from yellow to blue.

A target point Target represents coordinates of the reflection color of the main display area MDA, which were measured by the SCE measurement method. A comparison point Ref represents coordinates of the reflection color of the sub-display area SDA of the display device 10 according to the comparative example, which were measured by the SCE measurement method. A first point Ex1 represents coordinates of the reflection color of the sub-display area SDA of the display device 10 according to one embodiment of the present disclosure, which were measured by the SCE measurement method.

The sub-display area SDA of the display device 10 according to the comparative example exhibits a reflection color that is relatively close to yellow and green, whereas the sub-display area SDA of the display device 10 according to one embodiment of the present disclosure exhibits a reflection color that is substantially close to the reflection color of the main display area MDA.

In this way, in the display device 10 according to the present embodiment, the reflection color difference between the main display area MDA and the sub-display area SDA may be minimized or reduced by adjusting the area of the sub-color portion CF_S for each color.

Hereinafter, one or more embodiments of the display device according to present disclosure will be described. In the following embodiments, description of the same components as those of the above-described embodiment, which are denoted by like reference numerals, will not be provided or will be simplified, and only differences will be mainly described.

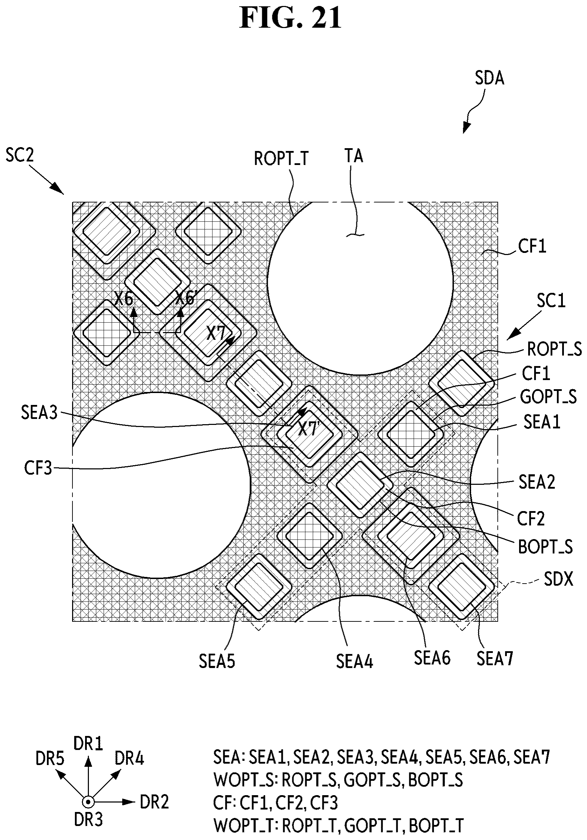

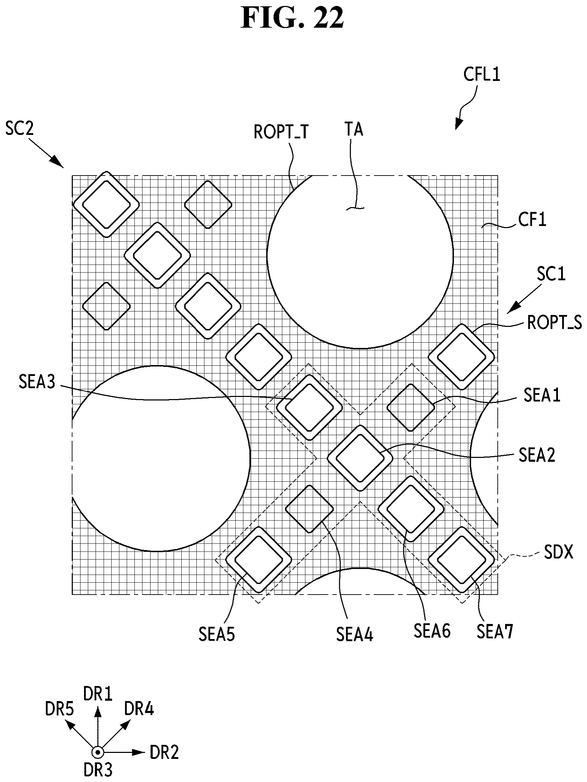

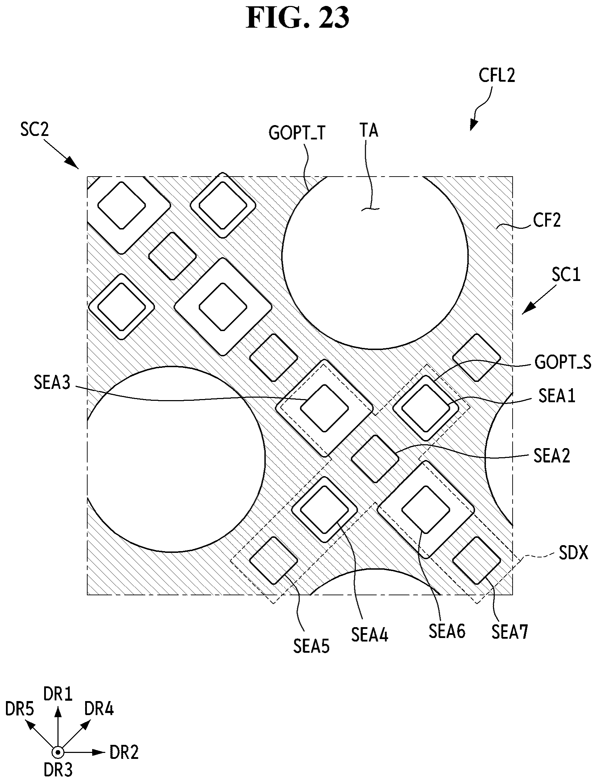

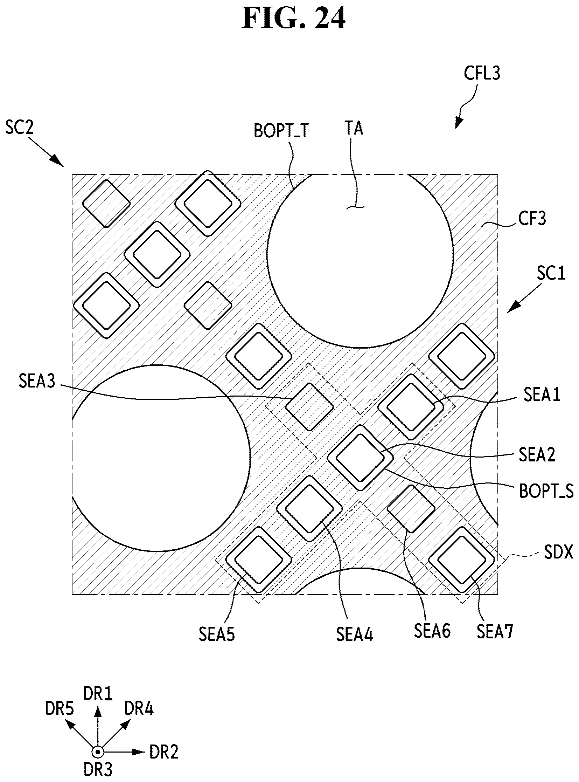

FIG. 21 is a layout diagram showing a first color filter layer, a second color filter layer, and a third color filter layer in a sub-display area according to one or more embodiments of the present disclosure. FIG. 22 is a layout diagram showing the first color filter layer in the sub-display area according to one or more embodiments. FIG. 23 is a layout diagram showing the second color filter layer in the sub-display area according to one or more embodiments. FIG. 24 is a layout diagram showing the third color filter layer in the sub-display area according to one or more embodiments.

Referring to FIGS. 21 to 24, the display device 10 according to one or more embodiments is different from the display device 10 according to one or more embodiments described with reference to FIG. 12 or the like in that it does not include the light blocking layer BM.

For example, the color filter layer CFL may not include (e.g., may exclude) the light blocking layer BM. For example, the color filter layer CFL may include only the first color filter layer CFL1, the second color filter layer CFL2, the third color filter layer CFL3, and the overcoat layer OC.

The first color filter layer CFL1 may include the first color filter CF1, the second color filter layer CFL2 may include the second color filter CF2, and the third color filter layer CFL3 may include the third color filter CF3. In one or more embodiments, the first color filter CF1 may be a red color filter, the second color filter CF2 may be a green color filter, and the third color filter CF3 may be a blue color filter.

The first to third color filters CF1, CF2, and CF3 may each be arranged over the entire surface of the display area DA. For example, the first to third color filters CF1, CF2, and CF3 may each be arranged over the main display area MDA and the sub-display area SDA.

The first color filter CF1 may cover the first sub-emission area SEA1 and the fourth sub-emission area SEA4. The second color filter CF2 may cover the second sub-emission area SEA2, the fifth sub-emission area SEA5, and the seventh sub-emission area SEA7. The third color filter CF3 may cover the third sub-emission area SEA3 and the sixth sub-emission area SEA6.

In the display device 10 according to the present embodiment, by forming the overlapping area of the first color filter CF1 of the first color filter layer CFL1, the second color filter CF2 of the second color filter layer CFL2, and the third color filter CF3 of the third color filter layer CFL3, the area where the light blocking layer BM of the display device 10 according to one or more embodiments is arranged may be implemented in substantially the same manner. For example, in the area where the first color filter CF1, the second color filter CF2, and the third color filter CF3 overlap, light emitted from the light emitting element ED may be blocked.

The first color filter CF1 may include a first sub-color opening ROPT_S. The second color filter CF2 may include a second sub-color opening GOPT_S. The third color filter CF3 may include a third sub-color opening BOPT_S. The first to third sub-color openings ROPT_S, GOPT_S, and BOPT_S may be included in a sub-color opening WOPT_S.

The first sub-color opening ROPT_S may overlap the second sub-emission area SEA2, the third sub-emission area SEA3, the fifth sub-emission area SEA5, the sixth sub-emission area SEA6, and the seventh sub-emission area SEA7. The second sub-color opening GOPT_S may overlap the first sub-emission area SEA1, the third sub-emission area SEA3, the fourth sub-emission area SEA4, and the sixth sub-emission area SEA6. The third sub-color opening BOPT_S may overlap the first sub-emission area SEA1, the second sub-emission area SEA2, the fourth sub-emission area SEA4, the fifth sub-emission area SEA5, and the seventh sub-emission area SEA7.

In the first sub-diagonal column SC1, the first sub-color opening ROPT_S and the second sub-color opening GOPT_S may be alternately arranged to be spaced and/or apart (e.g., spaced apart or separated) from each other in the fourth direction DR4. In the second sub-diagonal column SC2, the second sub-color opening GOPT_S and the third sub-color opening BOPT_S may be alternately arranged to be spaced and/or apart (e.g., spaced apart or separated) from each other in the fifth direction DR5.

A planar area of each of the plurality of sub-color openings WOPT_S may be larger than a planar area of each of the sub-emission areas SEA. For example, a planar area of the first sub-color opening ROPT_S may be larger than those of the second sub-emission area SEA2, the third sub-emission area SEA3, the fifth sub-emission area SEA5, the sixth sub-emission area SEA6, and the seventh sub-emission area SEA7, a planar area of the second sub-color opening GOPT_S may be larger than those of the first sub-emission area SEA1, the third sub-emission area SEA3, the fourth sub-emission area SEA4, and the sixth sub-emission area SEA6, and a planar area of the third sub-color opening BOPT_S may be larger than those of the first sub-emission area SEA1, the second sub-emission area SEA2, the fourth sub-emission area SEA4, the fifth sub-emission area SEA5, and the seventh sub-emission area SEA7.

The first color filter CF1 may include a first color transmission window opening ROPT_T arranged in the sub-display area SDA and arranged between a plurality of first sub-color openings ROPT_S, the second color filter CF2 may include a second color transmission window opening GOPT_T arranged in the sub-display area SDA and arranged between a plurality of second sub-color openings GOPT_S, and the third color filter CF3 may include a third color transmission window opening BOPT_T arranged in the sub-display area SDA and arranged between a plurality of third sub-color openings BOPT_S. The first color transmission window opening ROPT_T, the second color transmission window opening GOPT_T, and the third color transmission window opening BOPT_T may be included in the color transmission window opening WOPT_T.

The first color transmission window opening ROPT_T, the second color transmission window opening GOPT_T, and the third color transmission window opening BOPT_T may each be arranged in the transmission area TA. The first color transmission window opening ROPT_T, the second color transmission window opening GOPT_T, and the third color transmission window opening BOPT_T may completely overlap in the third direction DR3. The first color transmission window opening ROPT_T, the second color transmission window opening GOPT_T, and the third color transmission window opening BOPT_T may form one color transmission window opening WOPT_T.

In the display device 10 according to the present embodiment, the size or area of the second sub-color GOPT_S may be larger than the sizes or areas of the first sub-color opening ROPT_S and the third sub-color opening BOPT_S. For example, as illustrated in FIGS. 22 to 24, the sizes or areas of the second sub-color openings GOPT_S overlapping the third sub-emission area SEA3 and the sixth sub-emission area SEA6 among the second sub-color openings GOPT_S may be larger than the sizes or areas of the first sub-color opening ROPT_S and the third sub-color opening BOPT_S.

As described above, in order to minimize or reduce the color difference between the main display area MDA and the sub-display area SDA, the size or area of the second sub-color opening GOPT_S is formed to be larger than the sizes or areas of the first sub-color opening ROPT_S and the third sub-color opening BOPT_S, so that the amount of light reflected by the second sub-color opening GOPT_S may be decreased, and the amount of light reflected by the first sub-color opening ROPT_S and the third sub-color opening BOPT_S may be increased. Accordingly, the color difference between the main display area MDA and the sub-display area SDA may be minimized or reduced.

Although the presented embodiment in which the sizes or areas of the second sub-color openings GOPT_S overlapping the third sub-emission area SEA3 and the sixth sub-emission area SEA6 among the second sub-color openings GOPT_S are expanded is illustrated in the drawing, embodiments of the present disclosure are not limited thereto. For example, in one or more embodiments, the sizes or areas of the second sub-color openings GOPT_S overlapping the first sub-emission area SEA1 and the fourth sub-emission area SEA4 among the second sub-color openings GOPT_T may be expanded.

For example, if (e.g., when) it is desired or suitable to decrease a green color and increase a blue color, as in the former case, the sizes or areas of the second sub-color openings GOPT_S overlapping the third sub-emission area SEA3 and the sixth sub-emission area SEA6 among the second sub-color openings GOPT_S may be expanded, or, if (e.g., when) it is desired or suitable to decrease a green color and increase a red color, as in the latter case, the sizes or areas of the second sub-color openings GOPT_S overlapping the first sub-emission area SEA1 and the fourth sub-emission area SEA4 among the second sub-color openings GOPT_S may be expanded.

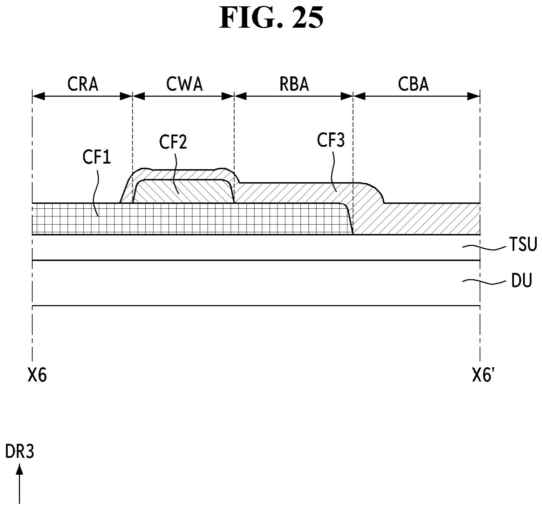

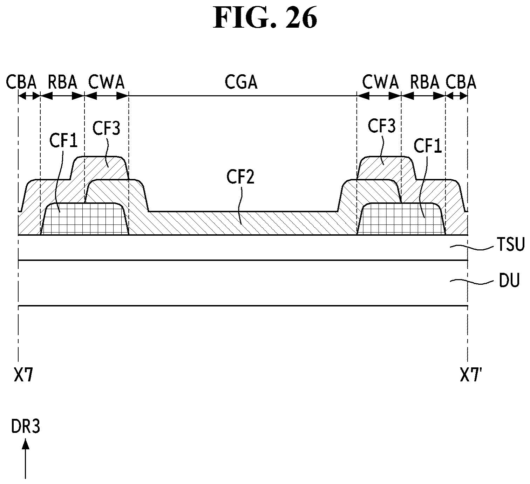

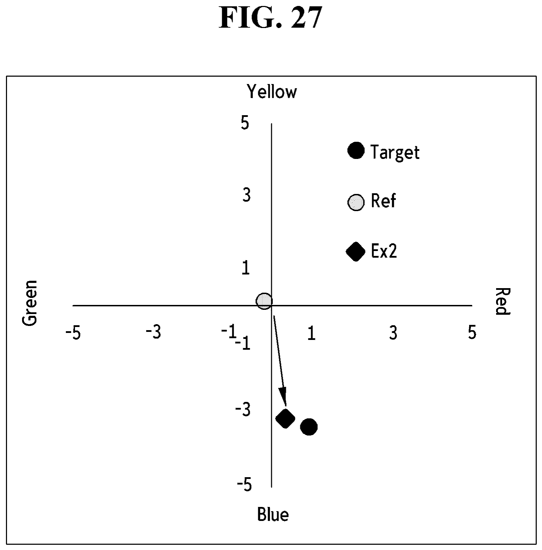

FIG. 25 is a cross-sectional view taken along the line X6-X6' in FIG. 21 according to one or more embodiments. FIG. 26 is a cross-sectional view taken along the line X7-X7' in FIG. 21 according to one or more embodiments. FIG. 27 is a graph showing a'-b' color difference plots of display devices according to a comparative example and one embodiment of the present disclosure, which were measured by the SCE measurement method.

Referring to FIG. 25 and FIG. 26 in addition to FIGS. 21 to 24, the sub-display area SDA may include a black blocking area CWA, a red transmission area CRA, a green transmission area CGA, a blue transmission area CBA, a red blocking area, a green blocking area RBA, and a blue blocking area.

The black blocking area CWA may be an area where all the first color filter CF1, the second color filter CF2, and the third color filter CF3 overlap in the third direction DR3. In the black blocking area CWA, all the light emitted from the sub-emission area SEA may be blocked.

The red transmission area CRA may be an area where only the first color filter CF1 is arranged, and may be an area where the second color filter CF2 and the third color filter CF3 are not arranged. The green transmission area CGA may be an area where only the second color filter CF2 is arranged, and may be an area where the first color filter CF1 and the third color filter CF3 are not arranged. The blue transmission area CBA may be an area where only the third color filter CF3 is arranged, and may be an area where the first color filter CF1 and the second color filter CF2 are not arranged.

The red blocking area may be an area where only the first color filter CF1 is not arranged, and may be an area where the second color filter CF2 and the third color filter CF3 overlap in the third direction DR3. The green blocking area RBA is an area where only the second color filter CF2 is not arranged, and may be an area where the first color filter CF1 and the third color filter CF3 overlap in the third direction DR3. The blue blocking area is an area where only the third color filter CF3 is not arranged, and may be an area where the first color filter CF1 and the second color filter CF2 overlap in the third direction DR3.

The display device 10 according to the present embodiment does not include the light blocking layer BM, and includes the black blocking area CWA where the first to third color filters CF1, CF2, and CF3 overlap, so that the same function as that of the light blocking layer BM may be implemented.

Meanwhile, in the display device 10 according to the present embodiment, the red transmission area CRA overlaps the first sub-emission area SEA1 and the fourth sub-emission area SEA4, the green transmission area CGA overlaps the second sub-emission area SEA2, the fifth sub-emission area SEA5, and the seventh sub-emission area SEA7, and the blue transmission area CBA overlaps the third sub-emission area SEA3 and the sixth sub-emission area SEA6, thereby increasing color reproducibility and color purity.

Further, in the display device 10 according to the present embodiment, the red blocking area, the green blocking area RBA, and the blue blocking area are included, so that the reflection color of the sub-display area SDA may be adjusted. For example, as described above, the reflection color difference between the main display area MDA and the sub-display area SDA may occur due to the unique color of the lower layer exposed in the transmission area TA of the sub-display area SDA. In order to minimize or reduce the difference, in the display device 10 according to the present embodiment, the areas of the red blocking area, the green blocking area RBA, and the blue blocking area may be each independently adjusted.

In one or more embodiments, in order to offset the color of yellow light reflected from the first passivation layer PAS1 (see FIG. 18), which is relatively yellow, the area of the green blocking area RBA may be increased near the blue transmission area CBA, as shown in FIGS. 25 and 26. In this case, the color difference between the main display area MDA and the sub-display area SDA may be minimized or reduced.

For example, as illustrated in FIG. 27, a second point Ex2 representing coordinates of the reflection color of the sub-display area SDA of the display device 10 according to the present embodiment, which were measured by the SCE measurement method, may be close to the target point Target representing coordinates of the reflection color of the main display area MDA, which were measured by the SCE measurement method.

The sub-display area SDA of the display device 10 according to the comparative example exhibits a reflection color that is relatively close to yellow and green, similarly to the comparison point Ref, whereas the sub-display area SDA of the display device 10 according to the present embodiment exhibits a reflection color that is substantially close to the reflection color of the main display area MDA, similarly to the second point Ex2.

In this way, in the display device 10 according to the present embodiment, the reflection color difference between the main display area MDA and the sub-display area SDA may be minimized or reduced by adjusting the area of the sub-color opening WOPT_S for each color.

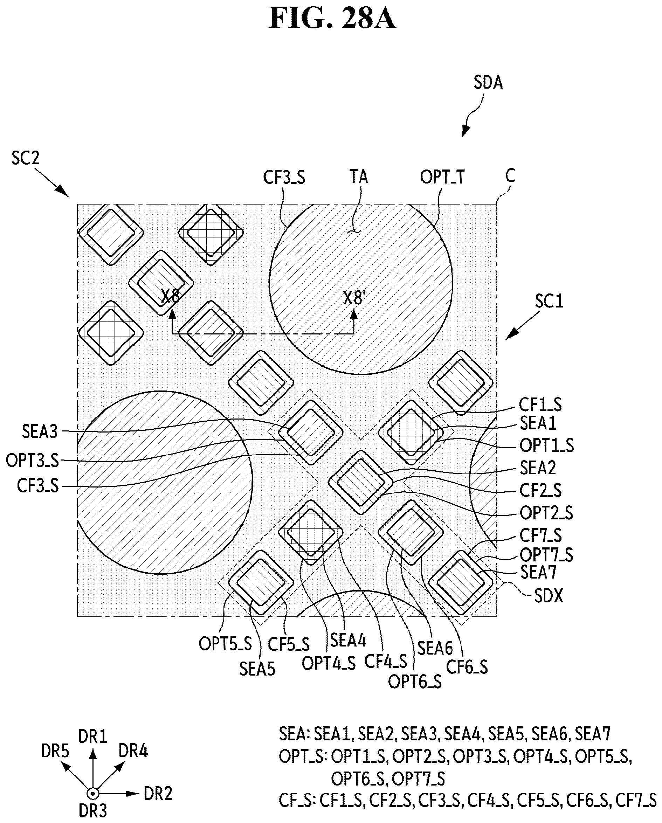

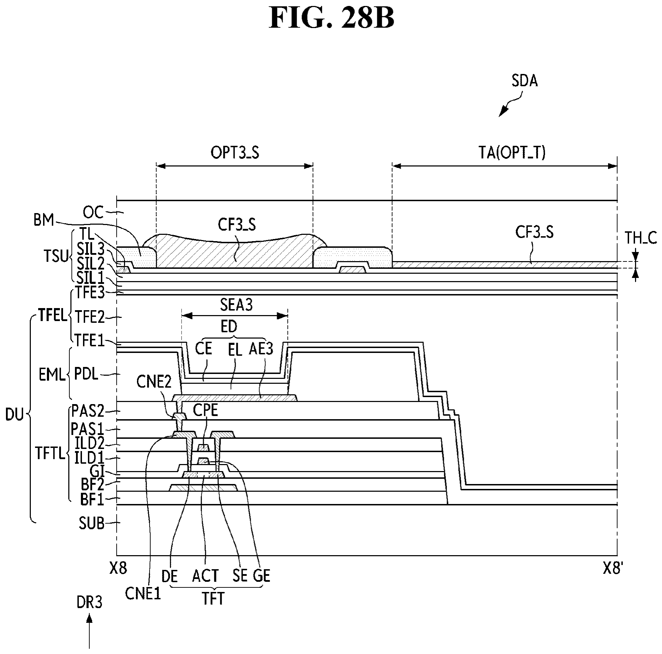

FIG. 28A is a plan view illustrating a sub-display area of a display device according to one or more embodiments of the present disclosure. FIG. 28B is a cross-sectional view taken along the line X8-X8' of FIG. 28A according to one or more embodiments.

Referring to FIG. 28 in addition to FIGS. 12 to 19, the display device 10 according to one or more embodiments is different from the display device 10 according to one or more embodiments described with reference to FIG. 18 and/or the like in that the sub-color portion CF_S is also arranged in the transmission area TA.

For example, the display device 10 according to the present embodiment may include the light blocking layer BM, the first color filter layer CFL1, the second color filter layer CFL2, and the third color filter layer CFL3, similarly to the display device 10 according to one or more embodiments described with reference to FIG. 12 and/or the like. Further, similarly to the display device 10 according to one or more embodiments described with reference to FIG. 12 and/or the like, the first sub-color portion CF1_S and the fourth sub-color portion CF4_S, which are red color filters, may overlap the first sub-emission area SEA1 and the fourth sub-emission area SEA4, respectively, the second sub-color portion CF2_S, the fifth sub-color portion CF5_S, and the seventh sub-color portion CF7_S, which are green color filters, may overlap the second sub-emission area SEA2, the fifth sub-emission area SEA5, and the seventh sub-emission area SEA7, respectively, and the third sub-color portion CF3_S and the sixth sub-color portion CF6_S, which are blue color filters, may overlap the third sub-emission area SEA3 and the sixth sub-emission area SEA6, respectively.

However, the display device 10 according to the present embodiment is different from the display device 10 according to one or more embodiments described with reference to FIG. 12 and/or the like, in that the size of the sub-color portion CF_S is substantially the same as the size of the sub-opening OPT_S.

For example, in the display device 10 according to one or more embodiments described with reference to FIG. 12 and/or the like, the sizes or areas of some of the sub-color portions CF_S are expanded to cover the top surface of the light blocking layer BM, but in the display device 10 according to the present embodiment, most of the sub-color portions CF_S may be arranged to overlap only the sub-opening OPT_S. To put it in other words, in some embodiments (like those shown in FIG. 12), the sub-color portions CF_S are made larger so that they cover the entire top surface of the light blocking layer BM. In other embodiment, most of the sub-color portions CF_S are positioned such that they only cover the sub-opening OPT_S, rather than the entire top surface of the light blocking layer BM. For example, in one or more embodiments, each of the sub-color portions CF_S may be arranged to overlap only its corresponding sub-opening OPT_S (e.g., confined to the sub-openings rather than expands the sub-color portions to cover more area).

However, the case in which the size of the sub-color portion CF_S is substantially the same as the size of the sub-opening OPT_S (i.e., corresponding sub-opening OPT_S) includes the case in which the width of the sub-color portion CF_S is substantially the same as the width of the sub-opening OPT_S, but both (e.g., simultaneously) ends of the sub-color portion CF_S cover a part of the top surface of the light blocking layer BM, as illustrated in FIGS. 28A and 28B. For example, it includes the case in which the sub-color portion CF_S does not cover most of the top surface of the light blocking layer BM, but slightly covers the top surface of the light blocking layer BM at both (e.g., simultaneously) ends of the light blocking layer BM adjacent to the sub-opening OPT_S. Here, the width of the sub-color portion CF_S that covers the top surface of the light blocking layer BM may be 10% or less of the width of the light blocking layer BM in cross-sectional view.

In the display device 10 according to one or more embodiments, the reflection color is improved by expanding the area of the sub-color portion CF_S to the top surface of the light blocking layer BM, whereas in the display device 10 according to the present embodiment, the reflection color may be improved by further disposing the sub-color portion CF_S in the transmission area TA.

For example, the display device 10 according to the present embodiment may further include the sub-color portion CF_S arranged in the transmission area TA. For example, as illustrated in FIGS. 28A and 28B, the third sub-color portion CF3_S may be further arranged in the transmission window opening OPT_T of the transmission area TA.

As described above, the color difference may occur between the sub-display area SDA and the main display area MDA due to the exposure of the unique color of the lower layer of the transmission area TA, but the color difference may be minimized or reduced by disposing the sub-color portion CF_S in the transmission area TA.

Although the case in which the third sub-color portion CF3_S is arranged in the transmission area TA is illustrated in the drawing, embodiments of the present disclosure are not limited thereto. Depending on the unique color of the lower layer, in one or more embodiments, the first sub-color portion CF1_S or the second sub-color portion CF2_S may be arranged in the transmission area TA. In one or more embodiments, two or more types (kinds) of sub-color portions CF_S selected from among the first to third sub-color portions CF1_S, CF2_S, and CF3_S may be arranged to overlap each other.

In one or more embodiments, in order to prevent or reduce the amount of light incident on the optical device 500 (see FIG. 3) in the transmission area TA from being reduced, a thickness TH_C of the sub-color portion CF_S arranged in the transmission area TA may be less than the thickness of the sub-color portion CF_S overlapping the sub-emission area SEA. In one or more embodiments, the thickness TH_C of the sub-color portion CF_S arranged in the transmission area TA may be approximately 1/30 to 1/2 of the thickness of the sub-color portion CF_S overlapping the sub-emission area SEA. For example, in one or more embodiments, the thickness of the sub-color portion CF_S overlapping the sub-emission area SEA may be approximately 0.1 micrometers (µm) to 1.5 µm.

In FIG. 28A and FIG. 28B, the case in which the light blocking layer BM is included, as in the display device 10 according to one or more embodiments described with reference to FIG. 12 and/or the like, has been described as an example, but embodiments of the present disclosure are not limited thereto. For example, the display device 10 according to one or more embodiments may not include (e.g., may exclude) the light blocking layer BM, as in the display device 10 according to one or more embodiments described with reference to FIG. 21 and/or the like.

In this regard, at least one of the first color transmission window opening ROPT_T, the second color transmission window opening GOPT_T, or the third color transmission window opening BOPT_T may not be arranged in the transmission area TA. For example, at least one of the first color filter CF1, the second color filter CF2, or the third color filter CF3 may cover the transmission area TA. For example, if (e.g., when) the third color transmission window opening BOPT_T is not arranged in the transmission area TA, the third color filter CF3 may cover the transmission area TA, and the same effect obtained if (e.g., when) the third sub-color portion CF3_S of FIG. 28B is arranged in the transmission area TA may be exhibited.

In the present disclosure, it will be understood that the terms "comprise(s)/comprising," "include(s)/including," or "have/has/having" specify the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having," or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

It will be understood that, although the terms "first," "second," "third," and/or the like, may be used herein to describe one or more suitable elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section described herein could be termed a second element, component, region, layer, or section, without departing from the scope of the present disclosure. In one or more embodiments, the terms "first", "second", and/or the like may also be used herein to differentiate different categories or sets of elements. For conciseness, the terms "first", "second", and/or the like may represent "first-category (or first-set)", "second-category (or second-set)", and/or the like, respectively. Further, in the disclosure, the phrase "on a plane," or "plan view," refers to viewing a target portion from the top, and the phrase "cross-sectional view" refers to viewing a cross-section formed by vertically cutting a target portion from a side, along a thickness direction.

In the present disclosure, expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof.

In the context of the present application and unless otherwise defined, the terms "use," "using," and "used" may be considered synonymous with the terms "utilize," "utilizing," and "utilized," respectively.

As utilized herein, the terms "substantially," "about," "approximately," or similar terms are used as terms of approximation and not as terms of degree, and are intended to account for the inherent deviations in measured or calculated values that would be recognized by those of ordinary skill in the art. "About" or "approximately" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein.

The light emitting element, the display module, the display device, the electronic device/apparatus, the device-manufacturing apparatus, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art would appreciate, in view of the present disclosure in its entirety, that each suitable feature of the various embodiments of the present disclosure may be combined or combined with one other, partially or entirely, and may be technically interlocked and operated in various suitable ways, and each embodiment may be implemented independently of one other or in conjunction with one other in any suitable manner unless otherwise stated or implied.

In concluding the detailed description, those skilled in the art will appreciate that many variations and modifications can be made to the example embodiments without substantially departing from the principles of the present disclosure. Therefore, the disclosed embodiments of present disclosure are used in a generic and descriptive sense only and not for purposes of limitation. It is further understood that the scope of the present disclosure is defined by the appended claims and equivalents thereof rather than the detailed description provided above, and all modifications and alterations derived from the claims and their equivalents fall within the scope of the present disclosure.

## Claims

1. A display device (10) comprising:
a display panel (100) comprising a main region (MDA) comprising a main pixel (MDX), and a sub-region (SDA) comprising a transmission area (TA) and a sub-pixel (SDX),
wherein the main pixel (MDX) comprises first to third main emission areas (MEA1, MEA2, MEA3) configured to emit light of first to third colors, respectively,
the sub-pixel (SDX) comprises first to third sub-emission areas (SEA1, SEA2, SEA3) configured to emit light of the first to third colors, respectively, and
the display panel comprises (100):
a display layer (DU);
a light blocking layer (BM) on the display layer (DU);
a first color filter layer (CFL1) on the light blocking layer (BM) and configured to transmit light of the first color;
a second color filter layer (CFL2) on the first color filter layer (CFL1) and configured to transmit light of the second color; and
a third color filter layer (CFL3) on the second color filter layer (CFL2) and configured to transmit light of the third color,
wherein the first to third color filter layers (CFL1, CFL2, CFL3) comprise first to third main color portions (CF1_M, CF2_M, CF3_M) overlapping the first to third main emission areas (MEA1, MEA2, MEA3), respectively, and first to third sub-color portions (CF1_S, CF2_S, CF3_S) overlapping the first to third sub-emission areas (SEA1, SEA2, SEA3), respectively, and
an area ratio between the first to third main color portions (CF1_M, CF2_M, CF3_M) is different from an area ratio between the first to third sub-color portions (CF1_S, CF2_S, CF3_S).

2. The display device (10) of claim 1, wherein an area of the second sub-color portion (CF2_S) is smaller than an area of each of the first sub-color portion (CF1_S) and the third sub-color portion (CF3_S), optionally wherein a second area obtained by excluding an area of the second sub-emission area (SEA2) from the area of the second sub-color portion (CF2_S) is smaller than at least one of a first area obtained by excluding an area of the first sub-emission area (SEA1) from the area of the first sub-color portion (CF1_S) or a third area obtained by excluding an area of the third sub-emission area (SEA3) from the area of the third sub-color portion (CF3_S).

3. The display device (10) of claim 1 or claim 2, wherein an area of the second sub-color portion (CF2_S) covering a top surface of the light blocking layer (BM) is smaller than at least one of an area of the first sub-color portion (CF1_S) covering a top surface of the light blocking layer (BM) or an area of the third sub-color portion (CF3_S) covering a top surface of the light blocking layer (BM).

4. The display device (10) of any one of claims 1 to 3, wherein the transmission area (TA) is repeatedly arranged in a first direction (DR1) and a second direction (DR2), on a plane viewed from a third direction (DR3),
the sub-region (SDA) comprises a central area (CTA) and a bridge area (BRA) where at least a part of the sub-pixel (SDX) is arranged,
the central area (CTA) is arranged between the transmission areas (TA) in the first direction (DR1) and the second direction (DR2), on the plane viewed from the third direction (DR3), and
the bridge area (BRA) is arranged between the transmission areas (TA) in a fourth direction (DR4) and a fifth direction (DR5) different from the first direction (DR1) and the second direction (DR2), on the plane viewed from the third direction (DR3).

5. The display device (10) of claim 4, wherein the first sub-emission area (SEA1) and the second sub-emission area (SEA2) are arranged alternately in the fourth direction (DR4), and
the second sub-emission area (SEA2) and the third sub-emission area (SEA3) are arranged alternately in the fifth direction (DR5).

6. The display device (10) of claim 5, wherein:
(i) a length of the first sub-color portion (CF1_S) in the fourth direction (DR4) is greater than a length thereof in the fifth direction (DR5), on the plane viewed from the third direction (DR3); and/or
(ii) in at least one of the fourth direction (DR4) or the fifth direction (DR5), a length of the third sub-color portion (CF3_S) is greater than that of the first sub-color portion (CF1_S), on the plane viewed from the third direction (DR3).

7. The display device (10) of any one of claims 4 to 6, wherein an area of the second sub-color portion (CF2_S) is smaller than an area of each of the first sub-color portion (CF1_S) and the third sub-color portion (CF3_S).

8. The display device (10) of any one of claims 4 to 7, wherein the sub-pixel (SDX) further comprises a fourth sub-emission area (SEA4) configured to emit light of the first color, a fifth sub-emission area (SEA5) configured to emit light of the second color, a sixth sub-emission area (SEA6) configured to emit light of the third color, and a seventh sub-emission area (SEA7) configured to emit light of the second color,
the first to fourth sub-emission areas (SEA1, SEA2, SEA3, SEA4) and the sixth sub-emission area (SEA6) are arranged in the central area (CTA), and
the fifth sub-emission area (SEA5) and the seventh sub-emission area (SEA7) are arranged in the bridge area (BRA).

9. The display device (10) of any one of claims 1 to 8, wherein:
(i) the light blocking layer (BM) comprises a transmission window opening (OPT_T) in the transmission area (TA); and/or
(ii) at least one selected from among the first to third sub-color portions (CF1_S, CF2_S, CF3_S) is arranged in the transmission area (TA).

10. A display device (10) comprising:
a display panel (100) comprising a main region (MDA) comprising a main pixel (MDX), and a sub-region (SDA) comprising a transmission area (TA) and a sub-pixel (SDX),
wherein the main pixel (MDX) comprises first to third main emission areas (MEA1, MEA2, MEA3) configured to emit light of first to third colors, respectively,
the sub-pixel (SDX) comprises first to third sub-emission areas (SEA1, SEA2, SEA3) configured to emit light of the first to third colors, respectively, and
the display panel (100) comprises:
a display layer (DU);
a first color filter layer (CFL1) on the display layer (DU) and configured to transmit light of the first color;
a second color filter layer (CFL2) on the first color filter layer (CFL1) and configured to transmit light of the second color; and
a third color filter layer (CFL3) on the second color filter layer (CFL2) and configured to transmit light of the third color,
wherein the first color filter layer (CFL1) comprises a first sub-color opening (ROPT_S) overlapping the second sub-emission area (SEA2) and the third sub-emission area (SEA3), and a first color transmission window opening (ROPT_T) in the transmission area (TA),
the second color filter layer (CFL2) comprises a second sub-color opening (GOPT_S) overlapping the first sub-emission area (SEA1) and the third sub-emission area (SEA3), and a second color transmission window opening (GOPT_T) in the transmission area (TA),
the third color filter layer (CFL3) comprises a third sub-color opening (BOPT_S) overlapping the first sub-emission area (SEA1) and the second sub-emission area (SEA2), and a third color transmission window opening (BOPT_T) in the transmission area (TA), and
the second sub-color opening (GOPT_S) has an area larger than that of at least one of the first sub-color opening (ROPT_S) or the third sub-color opening (BOPT_S).

11. The display device (10) of claim 10, wherein:
(i) the sub-region (SDA) comprises a black blocking area (CWA) where all the first to third color filter layers (CFL1, CFL2, CFL3) overlap; and/or
(ii) the sub-region (SDA) comprises a color blocking area (RBA) where the first color filter layer (CFL1) and the third color filter layer (CFL3) overlap and the second color filter layer (CFL2) is not arranged.

12. The display device (10) of claim 10 or claim 11, wherein an area of the second sub-color opening (GOPT_S) overlapping the first sub-emission area (SEA1) among the second sub-color openings (GOPT_S) is smaller than an area of the second sub-color opening (GOPT_S) overlapping the third sub-emission area (SEA3) among the second sub-color openings (GOPT_S).

13. The display device (10) of claim 12, wherein the transmission area (TA) is repeatedly arranged in a first direction (DR1) and a second direction (DR2), on a plane viewed from a third direction (DR3),
the sub-region (SDA) comprises a central area (CTA) and a bridge area (BRA) where at least a part of the sub-pixel (SDX) is arranged,
the central area (CTA) is arranged between the transmission areas (TA) in the first direction (DR1) and the second direction (DR2), on the plane viewed from the third direction (DR3), and
the bridge area (BRA) is arranged between the transmission areas (TA) in a fourth direction (DR4) and a fifth direction (DR5) different from the first direction (DR1) and the second direction (DR2), on the plane viewed from the third direction (DR3).

14. The display device (10) of claim 13, wherein:
(i) the first sub-emission area (SEA1) and the second sub-emission area (SEA2) are arranged alternately in a fourth direction (DR4), and
the second sub-emission area (SEA2) and the third sub-emission area (SEA3) are arranged alternately in a fifth direction (DR5); and/or
(ii) among the second sub-color openings (GOPT_S), the second sub-color opening (GOPT_S) overlapping the first sub-emission area (SEA1) is arranged in a fourth direction (DR4),
among the second sub-color openings (GOPT_S), the second sub-color opening (GOPT_S) overlapping the third sub-emission area (SEA3) is arranged in a fifth direction (DR5), and
at least one selected from among the first to third sub-color openings (ROPT_S, GOPT_S, BOPT_S) is not arranged in the transmission area (TA).

15. An electronic device comprising
a display device (10), wherein the display device (10) comprises:
a display panel (100) comprising a main region (MDA) comprising a main pixel (MDX), and a sub-region (SDA) comprising a transmission area (TA) and a sub-pixel (SDX),
wherein the main pixel (MDX) comprises first to third main emission areas (MEA1, MEA2, MEA3) configured to emit light of first to third colors, respectively,
the sub-pixel (SDX) comprises first to third sub-emission areas (SEA1, SEA2, SEA3) configured to emit light of the first to third colors, respectively, and
the display panel (100) comprises:
a display layer (DU);
a light blocking layer (BM) on the display layer (DU);
a first color filter layer (CFL1) on the light blocking layer (BM) and configured to transmit light of the first color;
a second color filter layer (CFL2) on the first color filter layer (CFL1) and configured to transmit light of the second color; and
a third color filter layer (CFL3) on the second color filter layer (CFL2) and configured to transmit light of the third color,
wherein the first to third color filter layers (CFL1, CFL2, CFL3) comprise first to third main color portions (CF1_M, CF2_M, CF3_M) overlapping the first to third main emission areas (MEA1, MEA2, MEA3), respectively, and first to third sub-color portions (CF1_S, CF2_S, CF3_S) overlapping the first to third sub-emission areas (SEA1, SEA2, SEA3), respectively, and
an area ratio between the first to third main color portions (CF1_M, CF2_M, CF3_M) is different from an area ratio between the first to third sub-color portions (CF1_S, CF2_S, CF3_S).
